# EUROPEAN PATENT SPECIFICATION

(11) **EP 1 730 770 B1**
(45) Date of publication and mention of the grant of the patent: **23.09.2015**
(21) Application number: 05722845.4
(22) Date of filing: 08.02.2005
(51) Int. Cl.: H01L 21/66, H01L 21/311

(54) **METHOD FOR TREATING A SUBSTRATE**
VERFAHREN ZUM BEHANDELN EINES SUBSTRATS
PROCEDE POUR TRAITER UN SUBSTRAT

(30) Priority: 30.03.2004 US 812347
(43) Date of publication of application: 13.12.2006
(73) Proprietor: Tokyo Electron Ltd., Tokyo 107-8481 (JP)
(72) Inventor: HIGUCHI, Fumihiko, Nakakoma-gun Yamanashi 409-3841 (JP); TAKAHASHI, Hiroyuki, North Andover, MA 01845 (US); KO, Akiteru, Peabody, MA 01960 (US); YUE, Hongyu, Plano, TX 75025 (US); YAMASHITA, Asao, Wappingers Falls, NY 12590 (US); KAMBARA, Hiromitsu Tokyo Electron U.S. Holdings Inc., Chandler AZ 85226 (US)
(74) Representative: Liesegang, Eva
(86) International application number: PCT/US2005/004037
(87) International publication number: WO 2005/104216

(56) References cited:
- US-A- 5 926 690
- US-A- 6 071 815
- US-A1- 2003 230 551
- SENDELBACH M ET AL: "FEEDFORWARD OF MASK OPEN MEASUREMENTS ON AN INTEGRATED SCATTEROMETER TO IMPROVE GATE LINEWIDTH CONTROL" PROCEEDINGS OF THE SPIE, SPIE, BELLINGHAM, VA, US, vol. 5375, no. PART 1, 24 May 2004 (2004-05-24), pages 686-702, XP002324242 ISSN: 0277-786X

## Description

### Field of the Invention

The present invention relates to a method for treating a substrate, and more particularly to a method for chemical and thermal treatment of a substrate.

### Background of the Invention

During semiconductor processing, a (dry) plasma etch process can be utilized to remove or etch material along fine lines or within vias or contacts patterned on a silicon substrate. The plasma etch process generally involves positioning a semiconductor substrate with an overlying patterned, protective layer, for example a photoresist layer, in a processing chamber. Once the substrate is positioned within the chamber, an ionizable, dissociative gas mixture is introduced within the chamber at a pre-specified flow rate, while a vacuum pump is throttled to achieve an ambient process pressure. Thereafter, a plasma is formed when a fraction of the gas species present are ionized by electrons heated via the transfer of radio frequency (RF) power either inductively or capacitively, or microwave power using, for example, electron cyclotron resonance (ECR). Moreover, the heated electrons serve to dissociate some species of the ambient gas species and create reactant specie(s) suitable for the exposed surface etch chemistry. Once the plasma is formed, selected surfaces of the substrate are etched by the plasma. The process is adjusted to achieve appropriate conditions, including an appropriate concentration of desirable reactant and ion populations to etch various features (e. g., trenches, vias, contacts, gates, etc.) in the selected regions of the substrate. Such substrate materials where etching is required include silicon dioxide (SiO₂), low-k dielectric materials, poly-silicon, and silicon nitride.

During material processing, etching such features generally comprises the transfer of a pattern formed within a mask layer to the underlying film within which the respective features are formed. The mask can, for example, comprise a light-sensitive material such as (negative or positive) photo-resist, multiple layers including such layers as photo-resist and an anti-reflective coating (ARC), or a hard mask formed from the transfer of a pattern in a first layer, such as photo-resist, to the underlying hard mask layer.

Sendelbach et al. "Feedforward of mask open measurements ...", paper presented at Conf. Metrology, Inspection, and Process Control for Microlithography XVIII 23-26 Feb. 2004, Santa Clara, CA, USA, published May 2004 in Proceedings of SPIE vol. 5375 describe a process of trimming a wafer in a chemical oxide removable (COR) process using a mixture of HF and NH₃ in a ratio of approximately 2:1. Trim amounts of between about 2 to 24 nm are controlled by time, pressure or temperature in the COR trim chamber.

US 6,071,815 A describes a method of patterning side walls of a trench in an etching process using a gaseous hydrogen fluoride-ammonia mixture. The etching process is performed at a particularly low pressure.

US 5,926,690 A describes a method for controlling critical dimensions during an etching process by adjusting a photoresist etch time; i.e. by adjusting the time during which a photoresist is etched prior to a polysilicon gate etch step.

US-A-2003/0230551 describes an etching system using a recipe generating means in a chemical oxide removal process. The flow rate of oxygen is used as a variable parameter and the critical dimension value is determined as a function of the oxygen flow rate. There is a linear control characteristic, from which it is derived that the oxygen flow rate is an effective control parameter for the control of the CD value. It is also mentioned that a flow rate of an additive gas such as N₂ can be adopted as the variable parameter without giving any details about how the influence of such an additive gas could be taken into account.

### SUMMARY OF THE INVENTION

The present invention relates to a method for treating a substrate according to claim 1.

### BRIEF DESCRIPTION OF THE DRAWINGS

In the accompanying drawings:
FIG. 1A illustrates a schematic representation of a transfer system for a chemical treatment system and a thermal treatment system which can be used for implementing the present invention;
FIG. 1B illustrates a schematic representation of a transfer system for a chemical treatment system and a thermal treatment system which can be used for implementing the present invention;
FIG. 1C illustrates a schematic representation of a transfer system for a chemical treatment system and a thermal treatment system which can be used for implementing the present invention;
FIG. 2 shows a schematic cross-sectional view of a processing system which can be used for implementing the present invention;
FIG. 3 shows a schematic cross-sectional view of a chemical treatment system which can be used for implementing the present invention;
FIG. 4 shows a perspective view of a chemical treatment system which can be used for implementing the present invention;
FIG. 5 shows a schematic cross-sectional view of a thermal treatment system which can be used for implementing the present invention;
FIG. 6 shows a perspective view of a thermal treatment system which can be used for implementing the present invention;
FIG. 7 illustrates a schematic cross-sectional view of a substrate holder which can be used for implementing the present invention;
FIG. 8 illustrates a schematic cross-sectional view of a gas distribution system which can be used for implementing the present invention;
FIG. 9A illustrates a schematic cross-sectional view of a gas distribution system which can be used for implementing the present invention;
FIG. 9B presents an expanded view of the gas distribution system shown in FIG. 9A which can be used for implementing the present invention;
FIGs. 10A and 10B present perspective views of the gas distribution system shown in FIG. 9A which can be used for implementing the present invention;
FIG. 11 shows a substrate lifter assembly which can be used for implementing the present invention;
FIG. 12 shows a side view of a thermal insulation assembly which can be used for implementing the present invention;
FIG. 13 shows a top view of a thermal insulation assembly which can be used for implementing the present invention;
FIG. 14 shows a cross-sectional side view of a thermal insulation assembly which can be used for implementing the present invention;
FIG. 15 shows a flow diagram for processing a substrate;
FIG. 16 presents exemplary data for a chemical oxide removal process;
FIG. 17 presents a control model for a chemical oxide removal process;
FIG. 18 presents an exploded view of the relationship depicted in FIG. 17;
FIG. 19 presents the sensitivity of the relationship depicted in FIG. 18;
FIG. 20 presents the sensitivity of the trim amount to changes in the flow rate of argon;
FIG. 21 presents another control model for a chemical oxide removal process;
FIG. 22 presents the sensitivity of the relationship depicted in FIG. 21;
FIGs. 23A and 23B illustrate a method of optimizing the relationship depicted in FIG. 21;
FIG. 24 presents another control model for a chemical oxide removal process; and
FIG. 25 illustrates a method of optimizing the relationship depicted in FIG. 21.

### DETAILED DESCRIPTION OF SEVERAL EMBODIMENTS

In material processing methodologies, pattern etching comprises the application of a thin layer of light-sensitive material, such as photoresist, to an upper surface of a substrate, that is subsequently patterned in order to provide a mask for transferring this pattern to the underlying thin film during etching. The patterning of the light-sensitive material generally involves exposure by a radiation source through a reticle (and associated optics) of the light-sensitive material using, for example, a micro-lithography system, followed by the removal of the irradiated regions of the light-sensitive material (as in the case of positive photoresist), or nonirradiated regions (as in the case of negative resist) using a developing solvent.

Additionally, multi-layer and hard masks can be implemented for etching features in a thin film. For example, when etching features in a thin film using a hard mask, the mask pattern in the light-sensitive layer is transferred to the hard mask layer using a separate etch step preceding the main etch step for the thin film. The hard mask can, for example, be selected from several materials for silicon processing including silicon dioxide (SiO₂) silicon nitride (Si₃N₄), or carbon, for example.

In order to reduce the feature size formed in the thin film, the hard mask can be trimmed laterally using, for example, a two-step process involving a chemical treatment of the exposed surfaces of the hard mask layer in order to alter the surface chemistry of the hard mask layer, and a post treatment of the exposed surfaces of the hard mask layer in order to desorb the altered surface chemistry.

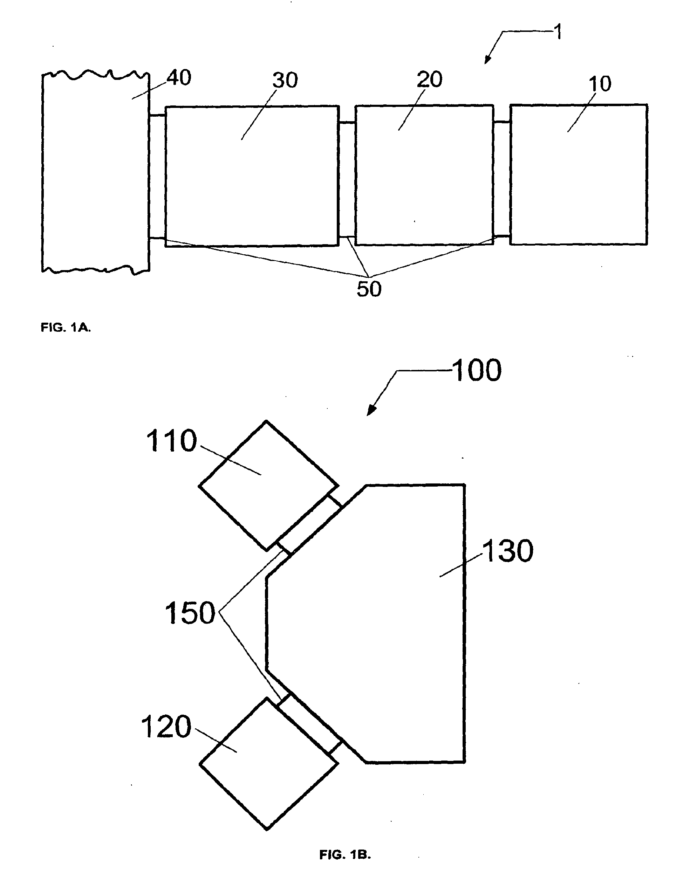

FIG. 1A presents a processing system 1 for processing a substrate using, for example, mask layer trimming. The processing system 1 comprises a first treatment system 10, and a second treatment system 20 coupled to the first treatment system 10. For example, the first treatment system 10 can comprise a chemical treatment system, and the second treatment system 20 can comprise a thermal treatment system. Alternately, the second treatment system 20 can comprise a substrate rinsing system, such as a water rinsing system. Also, as illustrated in FIG. 1A, a transfer system 30 can be coupled to the first treatment system 10 in order to transfer substrates into and out of the first treatment system 10 and the second treatment system 20, and exchange substrates with a multi-element manufacturing system 40. The first and second treatment systems 10, 20, and the transfer system 30 can, for example, comprise a processing element within the multi-element manufacturing system 40. For example, the multi-element manufacturing system 40 can permit the transfer of substrates to and from processing elements including such devices as etch systems, deposition systems, coating systems, patterning systems, metrology systems, etc. In order to isolate the processes occurring in the first and second systems, an isolation assembly 50 can be utilized to couple each system. For instance, the isolation assembly 50 can comprise at least one of a thermal insulation assembly to provide thermal isolation, and a gate valve assembly to provide vacuum isolation. Of course, treatment systems 10 and 20, and transfer system 30 can be placed in any sequence.

FIG. 1B presents an alternative processing system 100 for processing a substrate using a process such as mask layer trimming. The processing system 100 comprises a first treatment system 110, and a second treatment system 120. For example, the first treatment system 110 can comprise a chemical treatment system, and the second treatment system 120 can comprise a thermal treatment system. Alternately, the second treatment system 120 can comprise a substrate rinsing system, such as a water rinsing system. Also, as illustrated in FIG. 1B, a transfer system 130 can be coupled to the first treatment system 110 in order to transfer substrates into and out of the first treatment system 110, and can be coupled to the second treatment system 120 in order to transfer substrates into and out of the second treatment system 120. Additionally, transfer system 130 can exchange substrates with one or more substrate cassettes (not shown). Although only two process systems are illustrated in FIG. 1B, other process systems can access transfer system 130 including such devices as etch systems, deposition systems, coating systems, patterning systems, metrology systems, etc. In order to isolate the processes occurring in the first and second systems, an isolation assembly 150 can be utilized to couple each system. For instance, the isolation assembly 150 can comprise at least one of a thermal insulation assembly to provide thermal isolation, and a gate valve assembly to provide vacuum isolation. Additionally, for example, the transfer system 130 can serve as part of the isolation assembly 150.

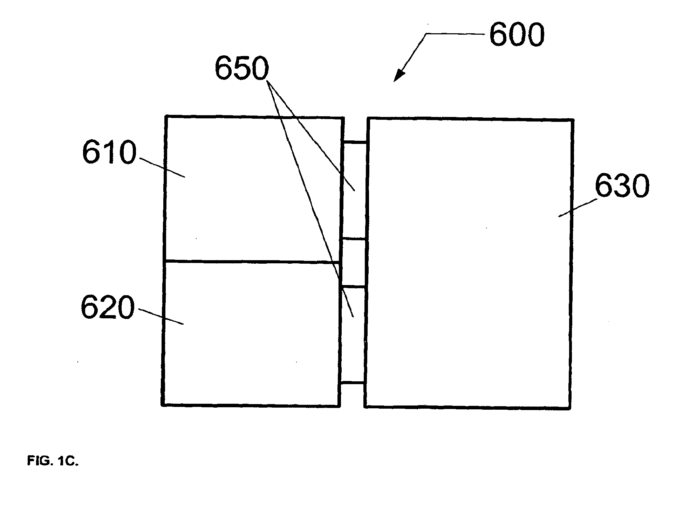

FIG. 1C presents an alternative processing system 600 for processing a substrate using a process such as mask layer trimming. The processing system 600 comprises a first treatment system 610, and a second treatment system 620, wherein the first treatment system 610 is stacked atop the second treatment system 620 in a vertical direction as shown. For example, the first treatment system 610 can comprise a chemical treatment system, and the second treatment system 620 can comprise a thermal treatment system. Alternately, the second treatment system 620 can comprise a substrate rinsing system, such as a water rinsing system. Also, as illustrated in FIG. 1C, a transfer system 630 can be coupled to the first treatment system 610 in order to transfer substrates into and out of the first treatment system 610, and can be coupled to the second treatment system 620 in order to transfer substrates into and out of the second treatment system 620. Additionally, transfer system 630 can exchange substrates with one or more substrate cassettes (not shown). Although only two process systems are illustrated in FIG. 1C, other process systems can access transfer system 630 including such devices as etch systems, deposition systems, coating systems, patterning systems, metrology systems, etc. In order to isolate the processes occurring in the first and second systems, an isolation assembly 650 can be utilized to couple each system. For instance, the isolation assembly 650 can comprise at least one of a thermal insulation assembly to provide thermal isolation, and a gate valve assembly to provide vacuum isolation. Additionally, for example, the transfer system 630 can serve as part of the isolation assembly 650.

In general, at least one of the first treatment system 10 and the second treatment system 20 of the processing system 1 depicted in FIG. 1A comprises at least two transfer openings to permit the passage of the substrate therethrough. For example, as depicted in FIG. 1A, the second treatment system 20 comprises two transfer openings, the first transfer opening permits the passage of the substrate between the second treatment system 20 and the transfer system 30 and the second transfer opening permits the passage of the substrate between the first treatment system and the second treatment system. However, regarding the processing system 100 depicted in FIG. 1B and the processing system 600 depicted in FIG. 1C, each treatment system 110, 120 and 610, 620, respectively, comprises at least one transfer opening to permit the passage of the substrate therethrough.

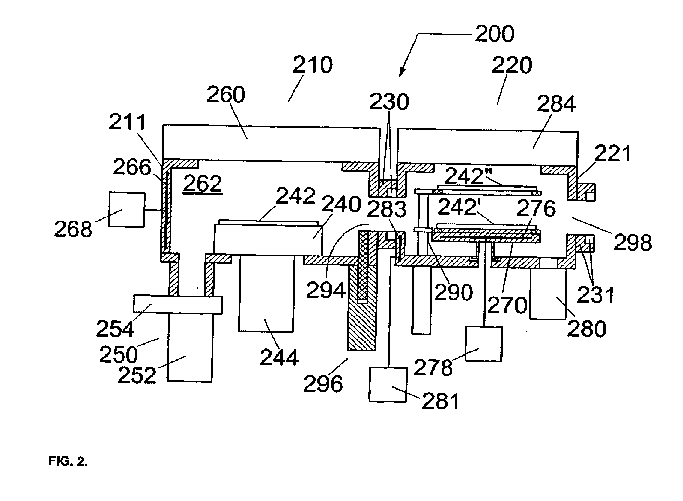

Referring now to FIG. 2, a processing system 200 for performing chemical treatment and thermal treatment of a substrate is presented. Processing system 200 comprises a chemical treatment system 210, and a thermal treatment system 220 coupled to the chemical treatment system 210. The chemical treatment system 210 comprises a chemical treatment chamber 211, which can be temperature-controlled. The thermal treatment system 220 comprises a thermal treatment chamber 221, which can be temperature-controlled. The chemical treatment chamber 211 and the thermal treatment chamber 221 can be thermally insulated from one another using a thermal insulation assembly 230, and vacuum isolated from one another using a gate valve assembly 296, to be described in greater detail below.

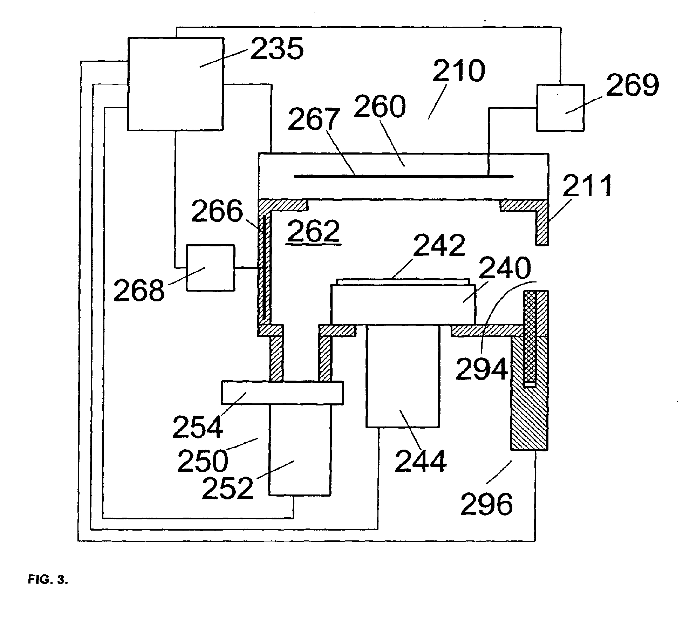

As illustrated in FIGs. 2 and 3, the chemical treatment system 210 further comprises a temperature controlled substrate holder 240 configured to be substantially thermally isolated from the chemical treatment chamber 211 and configured to support a substrate 242, a vacuum pumping system 250 coupled to the chemical treatment chamber 211 to evacuate the chemical treatment chamber 211, and a gas distribution system 260 for introducing a process gas into a process space 262 within the chemical treatment chamber 211.

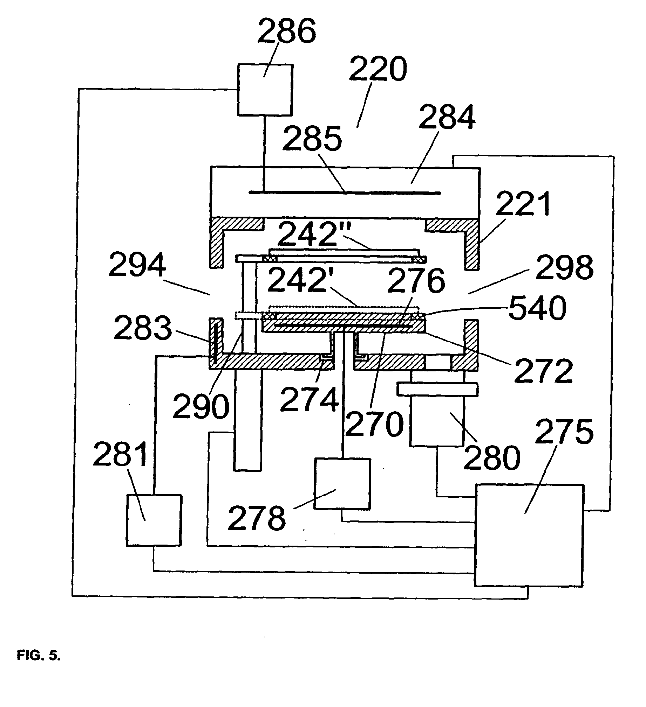

As illustrated in FIGs. 2 and 5, the thermal treatment system 220 further comprises a temperature controlled substrate holder 270 mounted within the thermal treatment chamber 221 and configured to be substantially thermally insulated from the thermal treatment chamber 221 and configured to support a substrate 242', a. vacuum pumping system 280 to evacuate the thermal treatment chamber 221, and a substrate lifter assembly 290 coupled to the thermal treatment chamber 221. Lifter assembly 290 can vertically translate the substrate 242" between a holding plane (solid lines) and the substrate holder 270 (dashed lines), or a transfer plane located therebetween. The thermal treatment chamber 221 can further comprise an upper assembly 284.

Additionally, the chemical treatment chamber 211, thermal treatment chamber 221, and thermal insulation assembly 230 define a common opening 294 through which a substrate can be transferred. During processing, the common opening 294 can be sealed closed using a gate valve assembly 296 in order to permit independent processing in the two chambers 211, 221. Furthermore, a transfer opening 298 can be formed in the thermal treatment chamber 221 in order to permit substrate exchanges with a transfer system as illustrated in FIG. 1A. For example, a second thermal insulation assembly 231 can be implemented to thermally insulate the thermal treatment chamber 221 from a transfer system (not shown). Although the opening 298 is illustrated as part of the thermal treatment chamber 221 (consistent with FIG. 1A), the transfer opening 298 can be formed in the chemical treatment chamber 211 and not the thermal treatment chamber 221 (reverse chamber positions as shown in FIG. 1A), or the transfer opening 298 can be formed in both the chemical treatment chamber 211 and the thermal treatment chamber 221 (as shown in FIGs. 1B and 1C).

As illustrated in FIGs. 2 and 3, the chemical treatment system 210 comprises a substrate holder 240, and a substrate holder assembly 244 in order to provide several operational functions for thermally controlling and processing substrate 242. The substrate holder 240 and substrate holder assembly 244 can comprise an electrostatic clamping system (or mechanical clamping system) in order to electrically (or mechanically) clamp substrate 242 to the substrate holder 240. Furthermore, substrate holder 240 can, for example, further include a cooling system having a re-circulating coolant flow that receives heat from substrate holder 240 and transfers heat to a heat exchanger system (not shown), or when heating, transfers heat from the heat exchanger system. Moreover, a heat transfer gas can, for example, be delivered to the back-side of substrate 242 via a backside gas system to improve the gas-gap thermal conductance between substrate 242 and substrate holder 240. The heat transfer gas supplied to the back-side of substrate 242 comprises an inert gas such as helium, argon, xenon, krypton, a process gas, or other gas such as oxygen, nitrogen, or hydrogen. Such a system can be utilized when temperature control of the substrate is required at elevated or reduced temperatures. For example, the backside gas system can comprise a multi-zone gas distribution system such as a two-zone (center-edge) system, wherein the back-side gas gap pressure can be independently varied between the center and the edge of substrate 242. In other embodiments, heating/cooling elements, such as resistive heating elements, or thermo-electric heaters/coolers can be included in the substrate holder 240, as well as the chamber wall of the chemical treatment chamber 211.

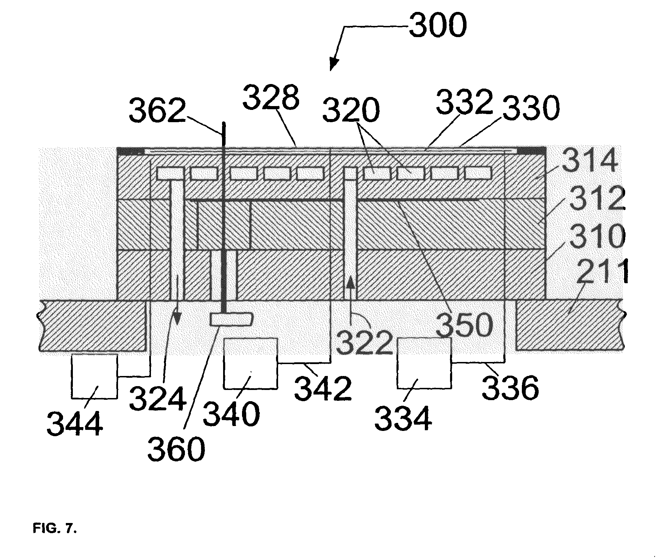

For example, FIG. 7 presents a temperature controlled substrate holder 300 for performing several of the above-identified functions. Substrate holder 300 comprises a chamber mating component 310 coupled to a lower wall of the chemical treatment chamber 211, an insulating component 312 coupled to the chamber mating component 310, and a temperature control component 314 coupled to the insulating component 312. The chamber mating and temperature control components 310, 314 can, for example, be fabricated from an electrically and thermally conducting material such as aluminum, stainless steel, nickel, etc. The insulating component 312 can, for example, be fabricated from a thermally-resistant material having a relatively lower thermal conductivity such as quartz, alumina, Teflon, etc.,

The temperature control component 314 can comprise temperature control elements such as cooling channels, heating channels, resistive heating elements, or thermo-electric elements. For example, as illustrated in FIG. 7, the temperature control component 314 comprises a coolant channel 320 having a coolant inlet 322 and a coolant outlet 324. The coolant channel 320 can, for example, be a spiral passage within the temperature control component 314 that permits a flow rate of coolant, such as water, Fluorinert, Galden HT-135, etc., in order to provide conductive-convective cooling of the temperature control component 314. Alternately, the temperature control component 314 can comprise an array of thermo-electric elements capable of heating or cooling a substrate depending upon the direction of electrical current flow through the respective elements. An exemplary thermo-electric element is one commercially available from Advanced Thermoelectric, Model ST-127-1.4-8.5M (a 40 mm by 40 mm by 3.4 mm thermo-electric device capable of a maximum heat transfer power of 72 W).

Additionally, the substrate holder 300 can further comprise an electrostatic clamp (ESC) 328 comprising a ceramic layer 330, a clamping electrode 332 embedded therein, and a high-voltage (HV) DC voltage supply 334 coupled to the clamping electrode 332 using an electrical connection 336. The ESC 328 can, for example, be mono-polar, or bi-polar. The design and implementation of such a clamp is well known to those skilled in the art of electrostatic clamping systems.

Additionally, the substrate holder 300 can further comprise a back-side gas supply system 340 for supplying a heat transfer gas, such as an inert gas including helium, argon, xenon, krypton, a process gas, or other gas including oxygen, nitrogen, or hydrogen, to the backside of substrate 242 through at least one gas supply line 342, and at least one of a plurality of orifices and channels. The backside gas supply system 340 can, for example, be a multi-zone supply system such as a two-zone (center-edge) system, wherein the backside pressure can be varied radially from the center to edge.

The insulating component 312 can further comprise a thermal insulation gap 350 in order to provide additional thermal insulation between the temperature control component 314 and the underlying mating component 310. The thermal insulation gap 350 can be evacuated using a pumping system (not shown) or a vacuum line as part of vacuum pumping system 250, and/or coupled to a gas supply (not shown) in order to vary its thermal conductivity. The gas supply can, for example, be the backside gas supply 340 utilized to couple heat transfer gas to the back-side of the substrate 242.

The mating component 310 can further comprise a lift pin assembly 360 capable of raising and lowering three or more lift pins, 362 in order to vertically translate substrate 242 to and from an upper surface of the substrate holder 300 and a transfer plane in the processing system.

Each component 310, 312, and 314 further comprises fastening devices (such as bolts and tapped holes) in order to affix one component to another, and to affix the substrate holder 300 to the chemical treatment chamber 211. Furthermore, each component 310, 312, and 314 facilitates the passage of the above-described utilities to the respective component, and vacuum seals, such as elastomer O-rings, are utilized where necessary to preserve the vacuum integrity of the processing system.

The temperature of the temperature-controlled substrate holder 240 can be monitored using a temperature sensing device 344 such as a thermocouple (e.g. a K-type thermocouple, Pt sensor, etc.). Furthermore, a controller can utilize the temperature measurement as feedback to the substrate holder assembly 244 in order to control the temperature of substrate holder 240. For example, at least one of a fluid flow rate, fluid temperature, heat transfer gas type, heat transfer gas pressure, clamping force, resistive heater element current or voltage, thermoelectric device current or polarity, etc. can be adjusted in order to affect a change in the temperature of substrate holder 240 and/or the temperature of the substrate 242.

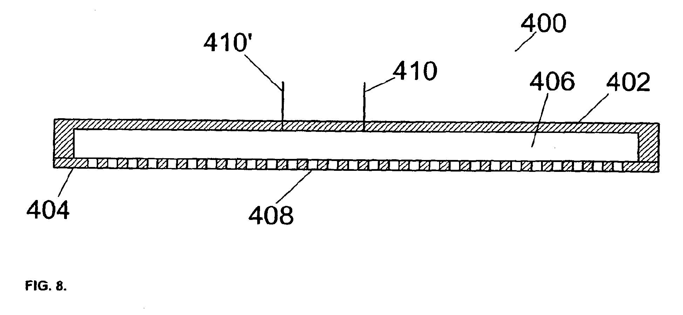

Referring again to FIGs. 2 and 3, chemical treatment system 210 comprises a gas distribution system 260. In one embodiment, as shown in FIG. 8, a gas distribution system 400 comprises a showerhead gas injection system having a gas distribution assembly 402, and a gas distribution plate 404 coupled to the gas distribution assembly 402 and configured to form a gas distribution plenum 406. Although not shown, gas distribution plenum 406 can comprise one or more gas distribution baffle plates. The gas distribution plate 404 further comprises one or more gas distribution orifices 408 to distribute a process gas from the gas distribution plenum 406 to the process space within chemical treatment chamber 211. Additionally, one or more gas supply lines 410, 410', etc. can be coupled to the gas distribution plenum 406 through, for example, the gas distribution assembly in order to supply a first process gas and a second process gas. The process gas can, for example, comprise NH₃, HF, H₂, O₂, CO, CO₂, Ar, He, etc.

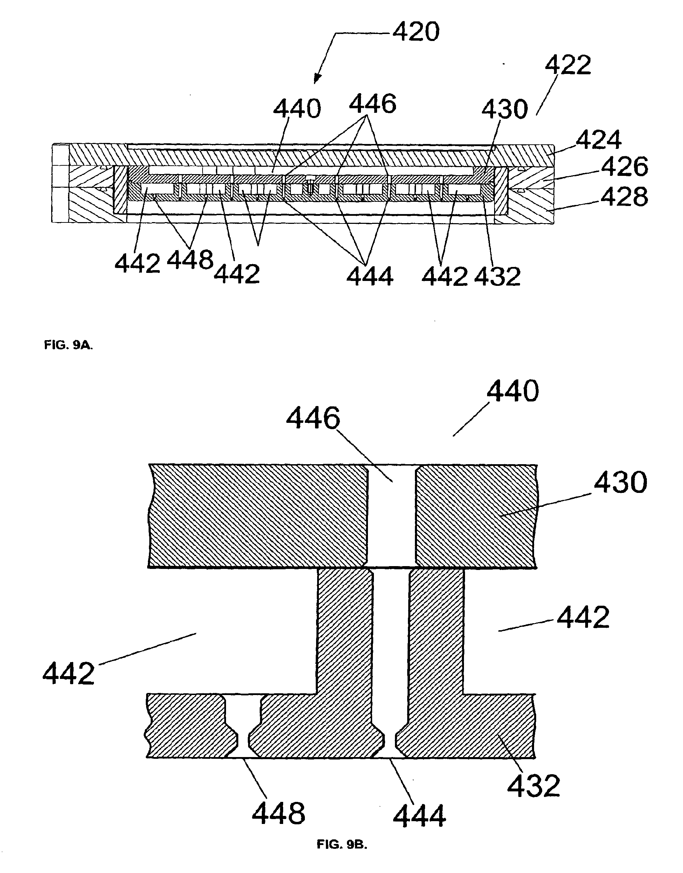

As shown in FIGs. 9A and 9B (expanded view of FIG. 9A), a gas distribution system 420 for distributing a process gas comprising at least two gases comprises a gas distribution assembly 422 having one or more components 424, 426, and 428, a first gas distribution plate 430 coupled to the gas distribution assembly 422 and configured to couple a first gas to the process space of chemical treatment chamber 211, and a second gas distribution plate 432 coupled to the first gas distribution plate 430 and configured to couple a second gas to the process space of chemical treatment chamber 211. The first gas distribution plate 430, when coupled to the gas distribution assembly 422, forms a first gas distribution plenum 440. Additionally, the second gas distribution plate 432, when coupled to the first gas distribution plate 430 forms a second gas distribution plenum 442. Although not shown, gas distribution plenums 440, 442 can comprise one or more gas distribution baffle plates. The second gas distribution plate 432 further comprises a first array of one or more orifices 444 coupled to and coincident with an array of one or more passages 446 formed within the first gas distribution plate 430, and a second array of one or more orifices 448. The first array of one or more orifices 444, in conjunction with the array of one or more passages 446, are configured to distribute the first gas from the first gas distribution plenum 440 to the process space of chemical treatment chamber 211. The second array of one or more orifices 448 is configured to distribute the second gas from the second gas distribution plenum 442 to the process space of chemical treatment chamber 211. The process gas can, for example, comprise NH₃, HF, H₂, O₂, CO, CO₂, Ar, He, etc. As a result of this arrangement, the first gas and the second gas are independently introduced to the process space without any interaction except in the process space.

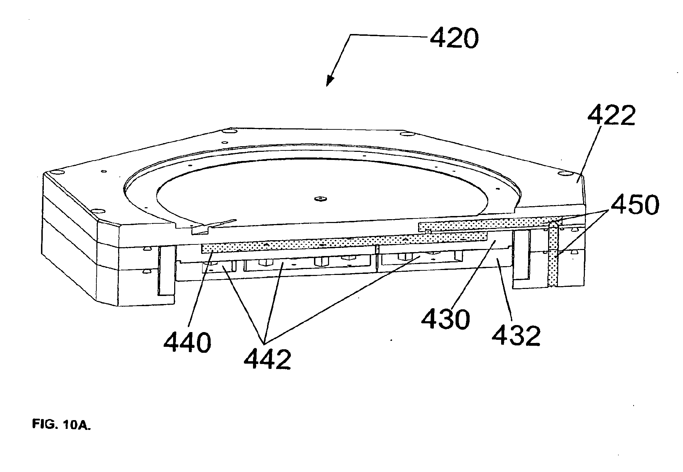

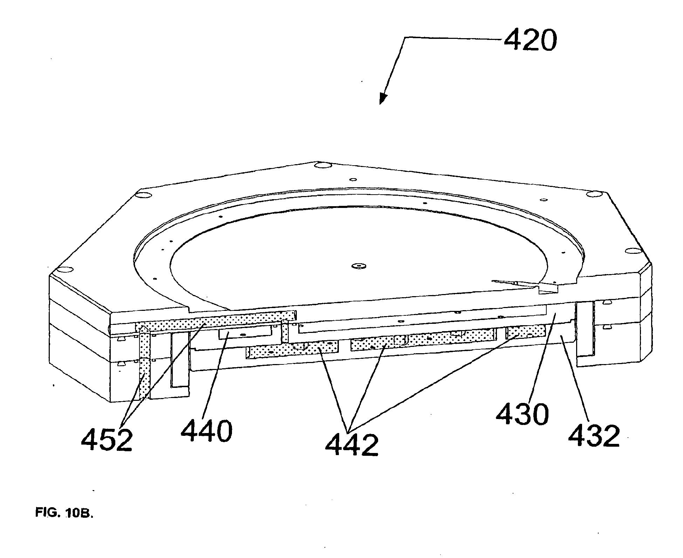

As shown in FIG. 10A, the first gas can be coupled to the first gas distribution plenum 440 through a first gas supply passage 450 formed within the gas distribution assembly 422. Additionally, as shown in FIG. 10B, the second gas can be coupled to the second gas distribution plenum 442 through a second gas supply passage 452 formed within the gas distribution assembly 422.

Referring again to FIGs. 2 and 3, chemical treatment system 220 further comprises a temperature controlled chemical treatment chamber 211 that is maintained at an elevated, temperature. For example, a wall heating element 266 can be coupled to a wall temperature control unit 268, and the wall heating element 266 can be configured to couple to the chemical treatment chamber 211. The heating element can, for example, comprise a resistive heater element such as a tungsten, nickel-chromium alloy, aluminum-iron alloy, aluminum nitride, etc., filament. Examples of commercially available materials to fabricate resistive heating elements include Kanthal, Nikrothal, and Akrothal, which are registered trademark names for metal alloys produced by Kanthal Corporation of Bethel, CT. The Kanthal family includes ferritic alloys (FeCrAl) and the Nikrothal family includes austenitic alloys (NiCr, NiCrFe). When an electrical current flows through the filament, power is dissipated as heat, and, therefore, the wall temperature control unit 268 can, for example, comprise a controllable DC power supply. For example, wall heating element 266 can comprise at least one Firerod cartridge heater commercially available from Watlow (1310 Kingsland Dr., Batavia, IL, 60510). A cooling element can also be employed in chemical treatment chamber 211. The temperature of the chemical treatment chamber 211 can be monitored using a temperature-sensing device such as a thermocouple (e.g. a K-type thermocouple, Pt sensor, etc.). Furthermore, a controller can utilize the temperature measurement as feedback to the wall temperature control unit 268 in order to control the temperature of the chemical treatment chamber 211.

Referring again to FIG. 3, chemical treatment system 210 can further comprise a temperature controlled gas distribution system 260 that can be maintained at any selected temperature. For example, a gas distribution heating element 267 can be coupled to a gas distribution system temperature control unit 269, and the gas distribution heating element 267 can be configured to couple to the gas distribution system 260. The heating element can, for example, comprise a resistive heater element such as a tungsten, nickel-chromium alloy, aluminum-iron alloy, aluminum nitride, etc., filament. Examples of commercially available materials to fabricate resistive heating elements include Kanthal, Nikrothal, and Akrothal, which are registered trademark names for metal alloys produced by Kanthal Corporation of Bethel, CT. The Kanthal family includes ferritic alloys (FeCrAl) and the Nikrothal family includes austenitic alloys (NiCr, NiCrFe). When an electrical current flows through the filament, power is dissipated as heat, and, therefore, the gas distribution system temperature control unit 269 can, for example, comprise a controllable DC power supply. For example, gas distribution heating element 267 can comprise a dual-zone silicone rubber heater (about 1 mm thick) capable of about 1400 W (or power density of about 5 W/in²). The temperature of the gas distribution system 260 can be monitored using a temperature-sensing device such as a thermocouple (e.g. a K-type thermocouple, Pt sensor, etc.). Furthermore, a controller can utilize the temperature measurement as feedback to the gas distribution system temperature control unit 269 in order to control the temperature of the gas distribution system 260. The gas distribution systems of FIGs. 8 -10B can also incorporate a temperature control system. Alternatively, or in addition, cooling elements can be employed in any of the embodiments.

Referring still to FIGs. 2 and 3, vacuum pumping system 250 can comprise a vacuum pump 252 and a gate valve 254 for throttling the chamber pressure. Vacuum pump 252 can, for example, include a turbo-molecular vacuum pump (TMP) capable of a pumping speed up to about 5000 liters per second (and greater). For example, the TMP can be a Seiko STP-A803 vacuum pump, or an Ebara ET1301W vacuum pump. TMPs are useful for low pressure processing, typically less than about 50 mTorr. For high pressure (i.e., greater than about 100 mTorr) or low throughput processing (i.e., no gas flow), a mechanical booster pump and dry roughing pump can be used.

Referring again to FIG. 3, chemical treatment system 210 can further comprise a controller 235 having a microprocessor, memory, and a digital I/O port capable of generating control voltages sufficient to communicate and activate inputs to chemical treatment system 210 as well as monitor outputs from chemical treatment system 210 such as temperature and pressure sensing devices. Moreover, controller 235 can be coupled to and can exchange information with substrate holder assembly 244, gas distribution system 260, vacuum pumping system 250, gate valve assembly 296, wall temperature control unit 268, and gas distribution system temperature control unit 269. For example, a program stored in the memory can be utilized to activate the inputs to the aforementioned components of chemical treatment system 210 according to a process recipe. One example of controller 235 is a DELL PRECISION WORKSTATION 610^{™}, available from Dell Corporation, Austin, Texas.

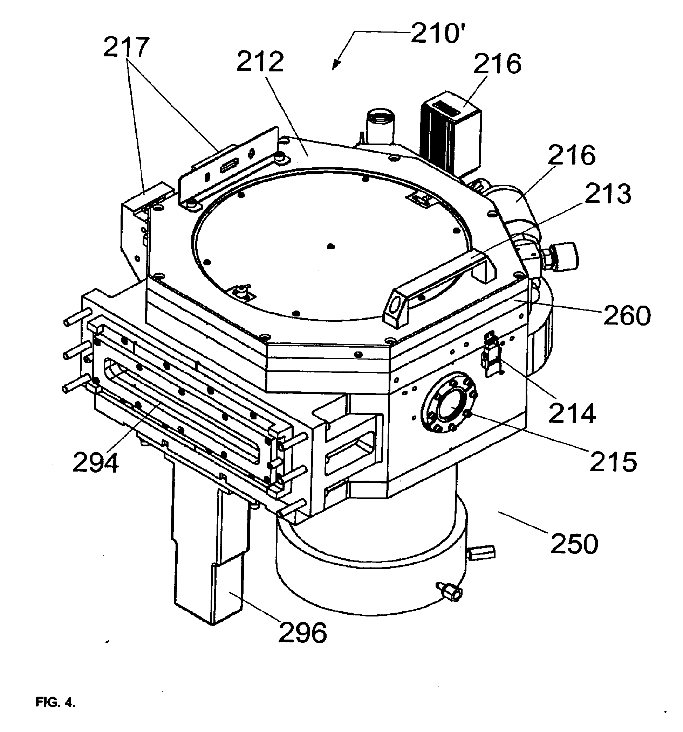

In one example, FIG. 4 presents a chemical treatment system 210' further comprising a lid 212 with a handle 213, at least one clasp 214, and at least one hinge 217, an optical viewport 215, and at least one pressure sensing device 216.

As described in FIGs. 2 and 5, the thermal treatment system 220 further comprises a temperature controlled substrate holder 270. The substrate holder 270 comprises a pedestal 272 thermally insulated from the thermal treatment chamber 221 using a thermal barrier 274. For example, the substrate holder 270 can be fabricated from aluminum, stainless steel, or nickel, and the thermal barrier 274 can be fabricated from a thermal insulator such as Teflon, alumina, or quartz. The substrate holder 270 further comprises a heating element 276 embedded therein and a substrate holder temperature control unit 278 coupled thereto. The heating element 276 can, for example, comprise a resistive heater element such as a tungsten, nickel-chromium alloy, aluminum-iron alloy, aluminum nitride, etc., filament. Examples of commercially available materials to fabricate resistive heating elements include Kanthal, Nikrothal, and Akrothal, which are registered trademark names for metal alloys produced by Kanthal Corporation of Bethel, CT. The Kanthal family includes ferritic alloys (FeCrAl) and the Nikrothal family includes austenitic alloys (NiCr, NiCrFe). When an electrical current flows through the filament, power is dissipated as heat, and, therefore, the substrate holder temperature control unit 278 can, for example, comprise a controllable DC power supply. Alternately, the temperature controlled substrate holder 270 can, for example, be a cast-in heater commercially available from Watlow (1310 Kingsland Dr., Batavia, IL, 60510) capable of a maximum operating temperature of about 400 to about 450 °C, or a film heater comprising aluminum nitride materials that is also commercially available from Watlow and capable of operating temperatures as high as about 300 °C and power densities of up to about 23 W/cm². Alternatively, a cooling element can be incorporated in substrate holder 270.

The temperature of the substrate holder 270 can be monitored using a temperature-sensing device such as a thermocouple (e.g. a K-type thermocouple). Furthermore, a controller can utilize the temperature measurement as feedback to the substrate holder temperature control unit 278 in order to control the temperature of the substrate holder 270.

Additionally, the substrate temperature can be monitored using a temperature-sensing device such as an optical fiber thermometer commercially available from Advanced Energies, Inc. (1625 Sharp Point Drive, Fort Collins, CO, 80525), Model No. OR2000F capable of measurements from about 50 to about 2000 °C and an accuracy of about plus or minus 1.5 °C, or a band-edge temperature measurement system as described in pending U.S. Patent Application 10/168544, filed on July 2, 2002, the contents of which are incorporated herein by reference in their entirety.

Referring again to FIG. 5, thermal treatment system 220 further comprises a temperature controlled thermal treatment chamber 221 that is maintained at a selected temperature. For example, a thermal wall heating element 283 can be coupled to a thermal wall temperature control unit 281, and the thermal wall heating element 283 can be configured to couple to the thermal treatment chamber 221. The heating element can, for example, comprise a resistive heater element such as a tungsten, nickel-chromium alloy, aluminum-iron alloy, aluminum nitride, etc., filament. Examples of commercially available materials to fabricate resistive heating elements include Kanthal, Nikrothal, and Akrothal, which are registered trademark names for metal alloys produced by Kanthal Corporation of Bethel, CT. The Kanthal family includes ferritic alloys (FeCrAl) and the Nikrothal family includes austenitic alloys (NiCr, NiCrFe). When an electrical current flows through the filament, power is dissipated as heat, and, therefore, the thermal wall temperature control unit 281 can, for example, comprise a controllable DC power supply. For example, thermal wall heating element 283 can comprise at least one Firerod cartridge heater commercially available from Watlow (1310 Kingsland Dr., Batavia, IL, 60510). Alternatively, or in addition, cooling elements may be employed in thermal treatment chamber 221. The temperature of the thermal treatment chamber 221 can be monitored using a temperature-sensing device such as a thermocouple (e.g. a K-type thermocouple, Pt sensor, etc.). Furthermore, a controller can utilize the temperature measurement as feedback to the thermal wall temperature control unit 281 in order to control the temperature of the thermal treatment chamber 221.

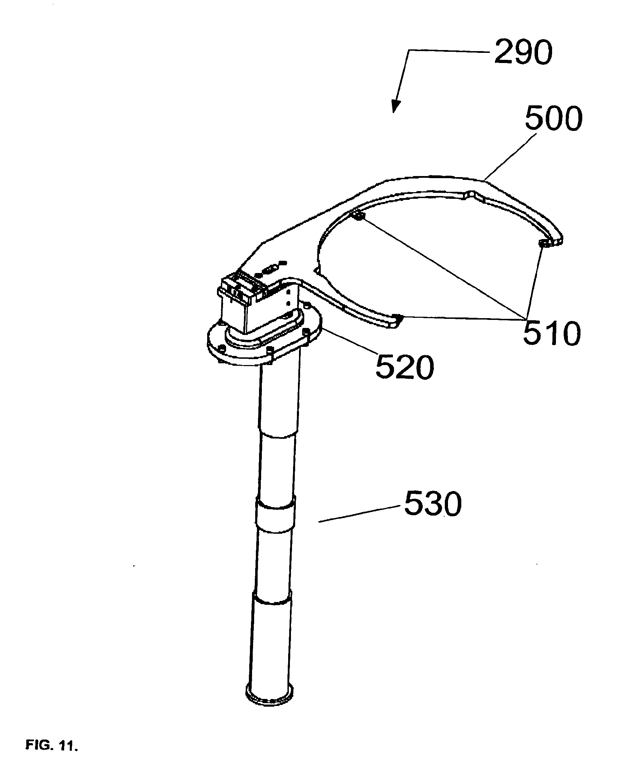

Referring still to FIGs. 2 and 5, thermal treatment system 220 further comprises an upper assembly 284. The upper assembly 284 can, for example, comprise a gas injection system for introducing a purge gas, process gas, or cleaning gas to the thermal treatment chamber 221. Alternately, thermal treatment chamber 221 can comprise a gas injection system separate from the upper assembly. For example, a purge gas, process gas, or cleaning gas can be introduced to the thermal treatment chamber 221 through a side-wall thereof. It can further comprise a cover or lid having at least one hinge, a handle, and a clasp for latching the lid in a closed position. In an alternate embodiment, the upper assembly 284 can comprise a radiant heater such as an array of tungsten halogen lamps for heating substrate 242" resting atop blade 500 (see FIG. 11) of substrate lifter assembly 290. In this case, the substrate holder 270 could be excluded from the thermal treatment chamber 221.

Referring again to FIG. 5, thermal treatment system 220 can further comprise a temperature controlled upper assembly 284 that can be maintained at a selected temperature. For example, an upper assembly heating element 285 can be coupled to an upper assembly temperature control unit 286, and the upper assembly heating element 285 can be configured to couple to the upper assembly 284. The heating element can, for example, comprise a resistive heater element such as a tungsten, nickel-chromium alloy, aluminum-iron alloy, aluminum nitride, etc., filament. Examples of commercially available materials to fabricate resistive heating elements include Kanthal, Nikrothal, and Akrothal, which are registered trademark names for metal alloys produced by Kanthal Corporation of Bethel, CT. The Kanthal family includes ferritic alloys (FeCrAl) and the Nikrothal family includes austenitic alloys (NiCr, NiCrFe). When an electrical current flows through the filament, power is dissipated as heat, and, therefore, the upper assembly temperature control unit 286 can, for example, comprise a controllable DC power supply. For example, upper assembly heating element 285 can comprise a dual-zone silicone rubber heater (about 1 mm thick) capable of about 1400 W (or power density of about 5 W/in²). The temperature of the upper assembly 284 can be monitored using a temperature-sensing device such as a thermocouple (e.g. a K-type thermocouple, Pt sensor, etc.). Furthermore, a controller can utilize the temperature measurement as feedback to the upper assembly temperature control unit 286 in order to control the temperature of the upper assembly 284. Upper assembly 284 may additionally or alternatively include a cooling element.

Referring again to FIGs. 2 and 5, thermal treatment system 220 further comprises a substrate lifter assembly 290. The substrate lifter assembly 290 is configured to lower a substrate 242' to an upper surface of the substrate holder 270, as well as raise a substrate 242" from an upper surface of the substrate holder 270 to a holding plane, or a transfer plane therebetween. At the transfer plane, substrate 242" can be exchanged with a transfer system utilized to transfer substrates into and out of the chemical and thermal treatment chambers 211, 221. At the holding plane, substrate 242" can be cooled while another substrate is exchanged between the transfer system and the chemical and thermal treatment chambers 211, 221. As shown in FIG. 11, the substrate lifter assembly 290 comprises a blade 500 having three or more tabs 510, a flange 520 for coupling the substrate lifter assembly 290 to the thermal treatment chamber 221, and a drive system 530 for permitting vertical translation of the blade 500 within the thermal treatment chamber 221. The tabs 510 are configured to grasp substrate 242" in a raised position, and to recess within receiving cavities 540 formed within the substrate holder 270 (see FIG. 5) when in a lowered position. The drive system 530 can, for example, be a pneumatic drive system designed to meet various specifications including cylinder stroke length, cylinder stroke speed, position accuracy, non-rotation accuracy, etc., the design of which is known to those skilled in the art of pneumatic drive system design.

Referring still to FIGs. 2 and 5, thermal treatment system 220 further comprises a vacuum pumping system 280. Vacuum pumping system 280 can, for example, comprise a vacuum pump, and a throttle valve such as a gate valve or butterfly valve. The vacuum pump can, for example, include a turbo-molecular vacuum pump (TMP) capable of a pumping speed up to about 5000 liters per second (and greater). TMPs are useful for low pressure processing, typically less than about 50 mTorr. For high pressure processing (i.e., greater than about 100 mTorr), a mechanical booster pump and dry roughing pump can be used.

Referring again to FIG. 5, thermal treatment system 220 can further comprise a controller 275 having a microprocessor, memory, and a digital I/O port capable of generating control voltages sufficient to communicate and activate inputs to thermal treatment system 220 as well as monitor outputs from thermal treatment system 220. Moreover, controller 275 can be coupled to and can exchange information with substrate holder temperature control unit 278, upper assembly temperature control unit 286, upper assembly 284, thermal wall temperature control unit 281, vacuum pumping system 280, and substrate lifter assembly 290. For example, a program stored in the memory can be utilized to activate the inputs to the aforementioned components of thermal treatment system 220 according to a process recipe. One example of controller 275 is a DELL PRECISION WORKSTATION 610^{™}, available from Dell Corporation, Austin, Texas.

In an alternate embodiment, controllers 235 and 275 can be the same controller.

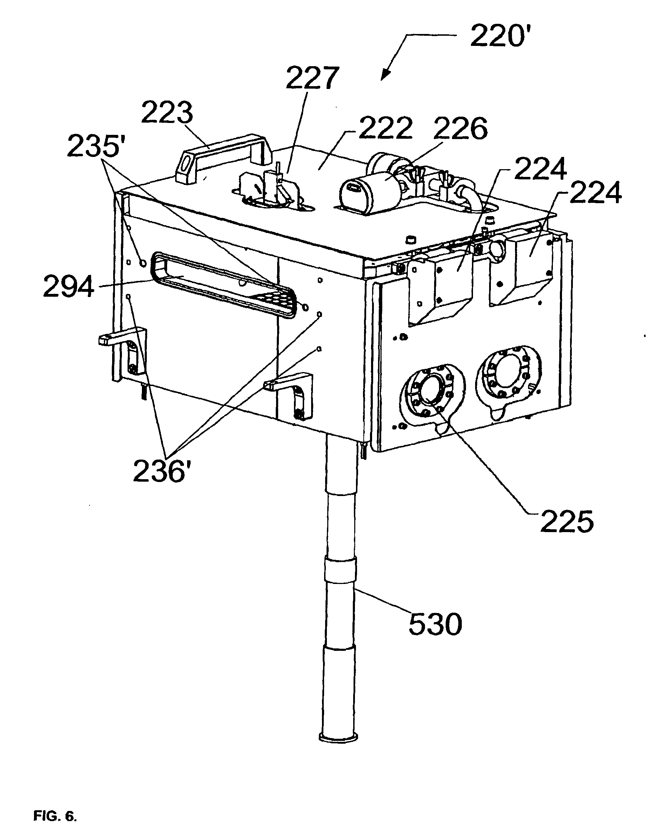

In one example, FIG. 6 presents a thermal treatment system 220' further comprising a lid 222 with a handle 223 and at least one hinge 224, an optical viewport 225, and at least one pressure sensing device 226. Additionally, the thermal treatment system 220' further comprises a substrate detection system 227 in order to identify whether a substrate is located in the holding plane. The substrate detection system can, for example, comprise a Keyence digital laser sensor.

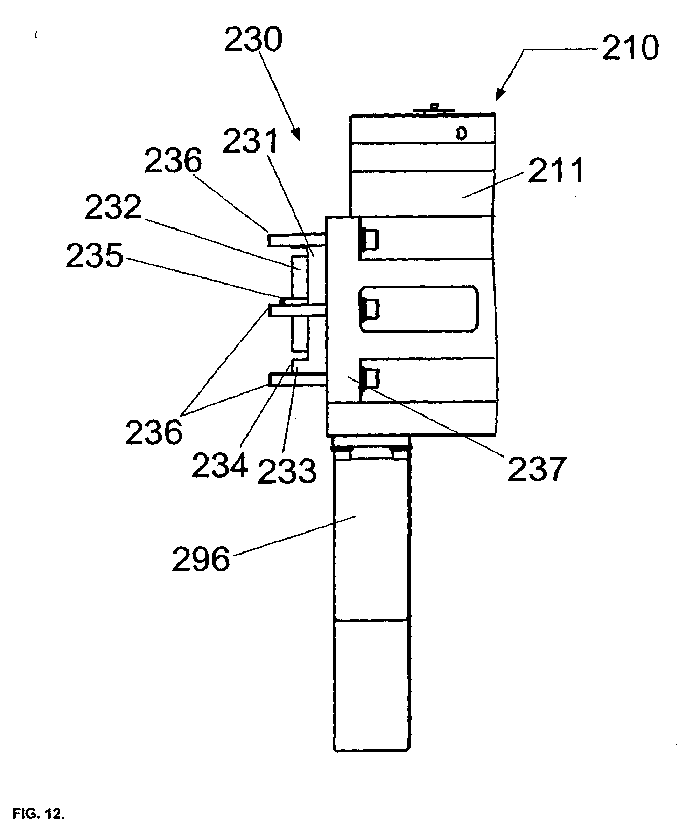

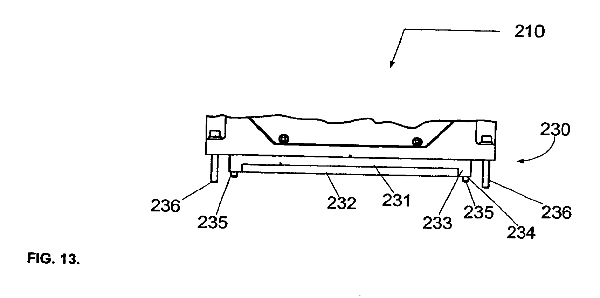

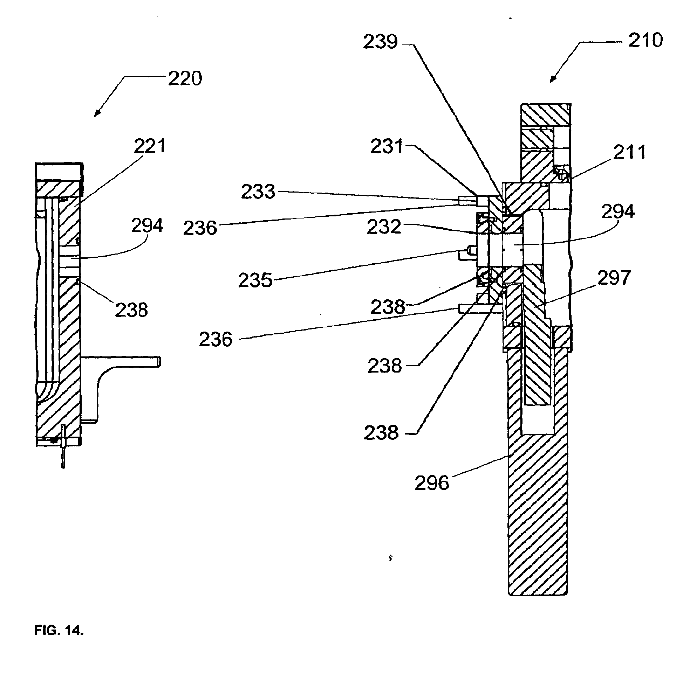

FIGs. 12, 13, and 14 depict a side view, a top view, and a side cross-sectional view, respectively, of thermal insulation assembly 230. A similar assembly can also be used as thermal insulation assembly 50, 150 or 650. The thermal insulation assembly 230 can comprise an interface plate 231 coupled to, for example, the chemical treatment chamber 211, as shown in FIG. 12, and configured to form a structural contact between the thermal treatment chamber 221 (see FIG. 14) and the chemical treatment chamber 211, and an insulator plate 232 coupled to the interface plate 231 and configured to reduce the thermal contact between the thermal treatment chamber 221 and the chemical treatment chamber 211. Furthermore, in FIG. 12, the interface plate 231 comprises one or more structural contact members 233 having a mating surface 234 configured to couple with a mating surface on the thermal treatment chamber 221. The interface plate 231 can be fabricated from a metal, such as aluminum, stainless steel, etc., in order to form a rigid contact between the two chambers 211, 221. The insulator plate 232 can be fabricated from a material having a low thermal conductivity such as Teflon, alumina, quartz, etc. A thermal insulation assembly is described in greater detail in pending U.S. Application No. 10/705,397, filed on November 12, 2003, and entitled, "Method and Apparatus For Thermally Insulating Adjacent Temperature Controlled Chambers", and it is incorporated by reference in its entirety.

As illustrated in FIGs. 2 and 14, gate valve assembly 296 is utilized to vertically translate a gate valve 297 in order to open and close the common opening 294. The gate valve assembly 296 can further comprise a gate valve adaptor plate 239 that provides a vacuum seal with the interface plate 231 and provides a seal with the gate valve 297.

The two chambers 211, 221 can be coupled to one another using one or more alignment devices 235 and terminating in one or more alignment receptors 235', as in FIG. 6, and one or more-fastening devices 236 (i.e. bolts) extending through a flange 237 on the first chamber (e.g. chemical treatment chamber 211) and terminating within one or more receiving devices 236', as in FIG. 6, (i.e. tapped hole) in the second chamber (e.g. thermal treatment chamber 221). As shown in FIG. 14, a vacuum seal can be formed between the insulator plate 232, the interface plate 231, the gate adaptor plate 239, and the chemical treatment chamber 211 using, for example, elastomer O-ring seals 238, and a vacuum seal can be formed between the interface plate 232 and the thermal treatment chamber 221 via O-ring seal 238.

Furthermore, one or more surfaces of the components comprising the chemical treatment chamber 211 and the thermal treatment chamber 221 can be coated with a protective barrier. The protective barrier can comprise at least one of Kapton, Teflon, surface anodization, ceramic spray coating such as alumina, yttria, etc., plasma electrolytic oxidation, etc.

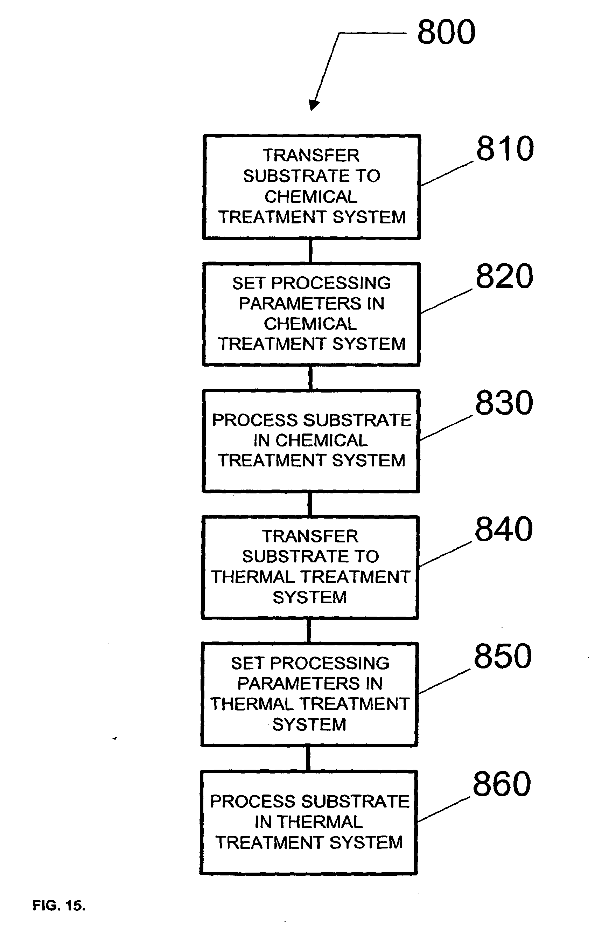

FIG. 15 presents a method of operating the processing system 200 comprising chemical treatment system 210 and thermal treatment system 220. The method is illustrated as a flowchart 800 beginning at 810 wherein a substrate is transferred to the chemical treatment system 210 using the substrate transfer system. The substrate is received by lift pins that are housed within the substrate holder, and the substrate is lowered to the substrate holder. Thereafter, the substrate is secured to the substrate holder using a clamping system, such as an electrostatic clamping system, and a heat transfer gas is supplied to the backside of the substrate.

At 820, one or more chemical processing parameters for chemical treatment of the substrate are set. For example, the one or more chemical processing parameters comprise at least one of a chemical treatment processing pressure, a chemical treatment wall temperature, a chemical treatment substrate holder temperature, a chemical treatment substrate temperature, a chemical treatment gas distribution system temperature, and a chemical treatment gas flow rate. For example, one or more of the following may occur: 1) a controller coupled to a wall temperature control unit and a first temperature-sensing device is utilized to set a chemical treatment chamber temperature for the chemical treatment chamber; 2) a controller coupled to a gas distribution system temperature control unit and a second temperature-sensing device is utilized to set a chemical treatment gas distribution system temperature for the chemical treatment chamber; 3) a controller coupled to at least one temperature control element and a third temperature-sensing device is utilized to set a chemical treatment substrate holder temperature; 4) a controller coupled to at least one of a temperature control element, a backside gas supply system, and a clamping system, and a fourth temperature sensing device in the substrate holder is utilized to set a chemical treatment substrate temperature; 5) a controller coupled to at least one of a vacuum pumping system, and a gas distribution system, and a pressure-sensing device is utilized to set a processing pressure within the chemical treatment chamber; and/or 6) the mass flow rates of the one or more process gases are set by a controller coupled to the one or more mass flow controllers within the gas distribution system.

At 830, the substrate is chemically treated under the conditions set forth at 820 for a first period of time. The first period of time can range from about 10 to about 480 seconds, for example.

At 840, the substrate is transferred from the chemical treatment chamber to the thermal treatment chamber. During which time, the substrate clamp is removed, and the flow of heat transfer gas to the backside of the substrate is terminated. The substrate is vertically lifted from the substrate holder to the transfer plane using the lift pin assembly housed within the substrate holder. The transfer system receives the substrate from the lift pins and positions the substrate within the thermal treatment system. Therein, the substrate lifter assembly receives the substrate from the transfer system, and lowers the substrate to the substrate holder.

At 850, thermal processing parameters for thermal treatment of the substrate are set. For example, the one or more thermal processing parameters comprise at least one of a thermal treatment wall temperature, a thermal treatment upper assembly temperature, a thermal treatment substrate temperature, a thermal treatment substrate holder temperature, a thermal treatment substrate temperature, and a thermal treatment processing pressure. For example, one or more of the following may occur: 1) a controller coupled to a thermal wall temperature control unit and a first temperature-sensing device in the thermal treatment chamber is utilized to set a thermal treatment wall temperature; 2) a controller coupled to an upper assembly temperature control unit and a second temperature-sensing device in the upper assembly is utilized to set a thermal treatment upper assembly temperature; 3) a controller coupled to a substrate holder temperature control unit and a third temperature-sensing device in the heated substrate holder is utilized to set a thermal treatment substrate holder temperature; 4) a controller coupled to a substrate holder temperature control unit and a fourth temperature-sensing device in the heated substrate holder and coupled to the substrate is utilized to set a thermal treatment substrate temperature; and/or 5) a controller coupled to a vacuum pumping system, a gas distribution system, and a pressure sensing device is utilized to set a thermal treatment processing pressure within the thermal treatment chamber.

At 860, the substrate is thermally treated under the conditions set forth at 850 for a second period of time. The second period of time can range from about 10 to about 480 seconds, for example.

In an example, the processing system 200, as depicted in FIG. 2, can be a chemical oxide removal system for trimming an oxide hard mask. The processing system 200 comprises chemical treatment system 210 for chemically treating exposed surface layers, such as oxide surface layers, on a substrate, whereby adsorption of the process chemistry on the exposed surfaces affects chemical alteration of the surface layers. Additionally, the processing system 200 comprises thermal treatment system 220 for thermally treating the substrate, whereby the substrate temperature is elevated in order to desorb (or evaporate) the chemically altered exposed surface layers on the substrate.

In the chemical treatment system 210, the process space 262 (see FIG. 2) is evacuated, and a process gas comprising HF and NH₃ is introduced. Alternately, the process gas can further comprise a carrier gas. The carrier gas can, for example, comprise an inert gas such as argon, xenon, helium, etc.

The processing pressure can range from about 1 to about 100 mTorr and, for example, can typically range from about 2 to about 25 mTorr. The process gas flow rates can range from about 1 to about 200 sccm for each specie and, for example, can range from about 10 to about 100 sccm. Although the vacuum pumping system 250 is shown in FIGs. 2 and 3 to access the chemical treatment chamber 211 from the side, a uniform (three-dimensional) pressure field can be achieved. Table I illustrates the percentage of pressure variation over the substrate surface as a function of processing pressure and the spacing between the gas distribution system 260 and the upper surface of substrate 242.

**TABLE I.**

| (%) | h (spacing) | | | | |
|---|---|---|---|---|---|
| Pressure | 50 mm | 62 | 75 | 100 | 200 |
| 20 mTorr | 0.6 | NA | NA | NA | NA |
| 9 | NA | NA | 0.75 | 0.42 | NA |
| 7 | 3.1 | 1.6 | 1.2 | NA | NA |
| 4 | 5.9 | 2.8 | NA | NA | NA |
| 3 | NA | 3.5 | 3.1 | 1.7 | 0.33 |

Additionally, the chemical treatment chamber 211 can be heated to a temperature ranging from about 10° to about 200° C and, for example, the temperature can range from about 35° to about 55° C. Additionally, the gas distribution system can be heated to a temperature ranging from 10 to 200 C and, for example, the temperature can range from about 40° to about 60° C. The substrate can be maintained at a temperature ranging from about 10° to about 50° C and, for example, the substrate temperature can range from about 25° to about 30° C.

In the thermal treatment system 220, the thermal treatment chamber 221 can be heated to a temperature ranging from about 20° to about 200° C and, for example, the temperature can range from about 75° to about 100° C. Additionally, the upper assembly can be heated to a temperature ranging from about 20° to about 200° C and, for example, the temperature can range from about 75° to about 100° C. The substrate can be heated to a temperature in excess of about 100° C ranging from about 100° to about 200° C. For example, the temperature can range from about 100° to about 150° C.

The chemical treatment and thermal treatment described herein can produce an etch amount of an exposed oxide surface layer in excess of about 10 nm per 60 seconds of chemical treatment for thermal oxide, an etch amount of the exposed oxide surface layer in excess of about 25 nm per 180 seconds of chemical treatment for thermal oxide, and an etch amount of the exposed oxide surface layer in excess of about 10 nm per 180 seconds of chemical treatment for ozone TEOS. The treatments can also produce an etch variation across the substrate of less than about 2.5%.

As described above, the process gas utilized in the chemical treatment system 210 can include HF and NH₃. Using the gas distribution assembly depicted in FIGs. 9A, 9B, 10A, and 10B, the first process gas HF is introduced to the process space in the chemical treatment system independent from the second process gas NH₃. Alternately, the two process gases are mixed and introduced to the process space as a mixture of gases.

Also, as described above, a chemically inert gas, such as a Noble gas, can be introduced with the first process gas HF, with the second process gas NH₃, independent of the first process gas HF and the second process gas NH₃, or any combination thereof. The Noble gas can, for example, include argon.

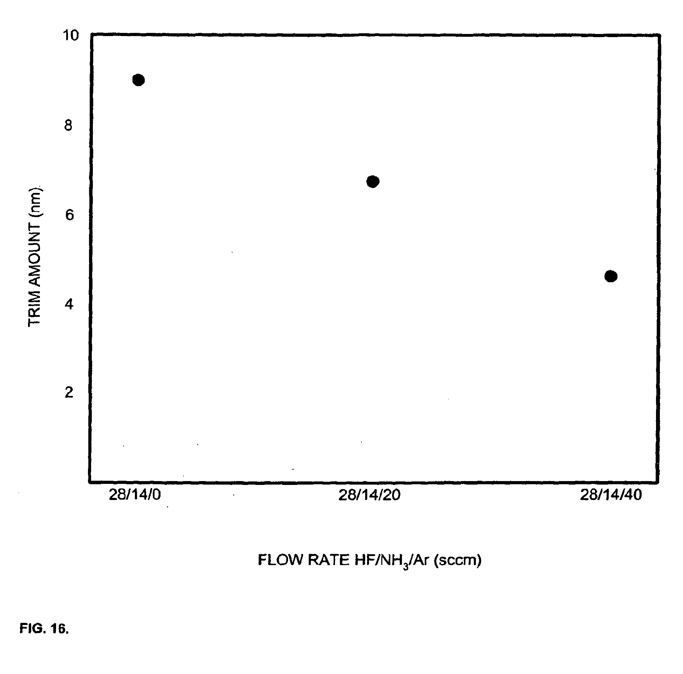

In an example, argon is introduced to the second process gas NH₃, and the trim amount (of silicon oxide) is observed to decrease as the flow rate of argon is increased. FIG. 16 presents a trim amount (nm) as a function of the flow rate of argon, while all other conditions were held constant. For each data point, the flow rate of HF was about 28 sccm, the flow rate of NH₃ was about 14 sccm, the pressure was about 15 mTorr, the substrate holder temperature was about 20° C, the wall temperature of the chemical treatment chamber was about 40° C, the time period for exposure to the HF/NH₃ chemistry was about 60 seconds, the spacing between the gas distribution plate and the substrate was about 56 mm, and the flow rate of argon was varied from about 0 to about 40 sccm. A curve fit of the empirical data in FIG. 16 is used to define a relationship between the trim amount and the flow rate of inert gas. For instance, multiple curve fits of the empirical data in FIG. 16 can be used to define one or more relationships between the trim amount and the flow rate of inert gas. Alternatively, for instance, interpolation and extrapolation of the empirical data in FIG. 16 can be used to define a relationship between the trim amount and the flow rate of inert gas. Although the preceding description presents a relationship between the trim amount and the flow rate of inert gas, the relationship can be established between a trim amount and an amount of inert gas for a given amount of a first process gas and a given amount of a second process gas. For example, the amount of gas can include a mass flow rate, a molar flow rate, a gas concentration, a partial pressure, etc.

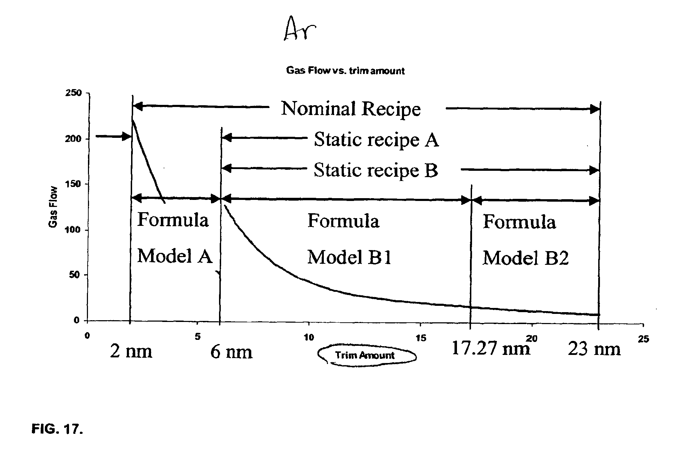

In another example, FIG. 17 illustrates a graph of another exemplary process using the data presented in Table 2. FIG. 17 presents the flow rate of argon as a function of trim amount (of silicon dioxide). For instance, multiple curve fits of the empirical data in FIG. 17 can be used to define one or more relationships between the trim amount and the flow rate of inert gas.

In FIG. 17, several processing regimes are shown. In a first processing regime, the process result (trim amount) varies from approximately 2 nm to approximately 6 nm; in a second processing regime, the process result (trim amount) varies from approximately 6 nm to approximately 17.3 nm; and in a third processing regime, the process result (trim amount) varies from approximately 17.3 nm to approximately 23 nm. In alternate embodiments, there can be a different number of processing regimes, and the limits can be different.

**Table 2**

| Trim (nm) | Ar (sccm) | Recipe |
|---|---|---|
| 2 | 219 | A |
| 3 | 156 | A |
| 4 | 107 | A |
| 5 | 73.8 | A |
| 6 | 53.2 | A |
| 7 | 100 | B |
| 8 | 74.5 | B |
| 9 | 56.6 | B |
| 10 | 44.3 | B |
| 11 | 36.1 | B |
| 12 | 30.6 | B |
| 13 | 26.8 | B |
| 14 | 24 | B |
| 15 | 21.8 | B |
| 16 | 19.9 | B |
| 17 | 18.2 | B |
| 18 | 16.5 | B |
| 19 | 14.9 | B |
| 20 | 13.3 | B |
| 21 | 11.9 | B |
| 22 | 10.6 | B |
| 23 | 9.5 | B |

In each processing regime, an equation can be used to calculate the relationship between the process result (trim amount) and the process parameter (gas flow). The process recipe can comprise at least one of: a nominal recipe component, a static recipe component, and a formula model component. Alternately, a different number of components and/or different types of components can be used.

As shown in the illustrated embodiment, the process recipe used in the first processing regime can comprise a nominal recipe component, a static recipe A component, and a formula model A component; the process recipe used in the second processing regime can comprise a nominal recipe component, a static recipe B component, and a formula model B1 component; and the process recipe used in the third processing regime can comprise a nominal recipe component, a static recipe B component, and a formula model B2 component. For example, the nominal recipe component spans the entire range of the trim data, i.e., a trim amount of 2 nm to 23 nm as shown in FIG. 17. Additionally, for example, the nominal recipe component can be dissected into two or more static recipe components, i.e., static recipe A component and static recipe B component as shown in FIG. 17. Each static recipe component (e.g., component A and B) can be designed for a range of trim amount, i.e., component A spans a trim amount of 2 nm to 6 nm, and component B spans a trim amount of 6 nm to 23 nm (see FIG. 17). Furthermore, each static recipe component can include a different amount of the first reactant, a different amount of the second reactant, and a different process pressure (e.g., the amount of the first reactant, the amount of the second reactant and the process pressure are constant for the span of static recipe A component, and the amount of the first reactant, the amount of the second reactant and the process pressure are constant for the span of static recipe B component). Additionally, for example, each static recipe component (i.e., component A and B) can be represented by one or more formula model components. For example, as shown in FIG. 17, static recipe A component is represented by one formula model component, namely, formula model A component, and static recipe B component is represented by two formula model components, namely, formula model B1 component and formula model B2 component. The use of two or more formula model components can, for instance, permit using different model fits (e.g., data fitting using at least one of a polynomial expression, a power law, an exponential law, etc.) in order to obtain the optimal data fitting for different regions of a static recipe component.

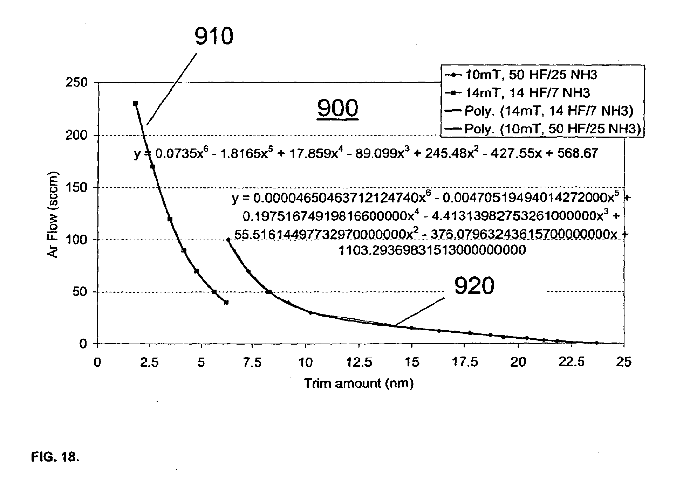

For example, FIG. 18 presents a control model 900 illustrating a relationship between the flow rate of argon (sccm) and the trim amount (nm). The control model 900 is shown to have a first process recipe 910 for a first processing regime, and a second process recipe 920 for a second processing regime. The first process recipe 910 corresponds to a flow rate of HF of about 14 sccm, a flow rate of NH₃ of about 7 sccm, and a pressure of about 14 mTorr. The second process recipe 920 corresponds to a flow rate of HF of about 50 sccm, a flow rate of NH₃ of about 25 sccm, and a pressure of about 10 mTorr.

Multiple curve fits of the empirical data in FIG. 18 are used to define two relationships between the trim amount and the flow rate of inert gas for each processing regime, respectively. One or more of the multiple curve-fits can include a polynomial fit. For example, a first curve-fit of the first process recipe 910 is illustrated as a sixth order polynomial expression, and a second curve-fit of the second process recipe 920 is illustrated as a sixth order polynomial expression.

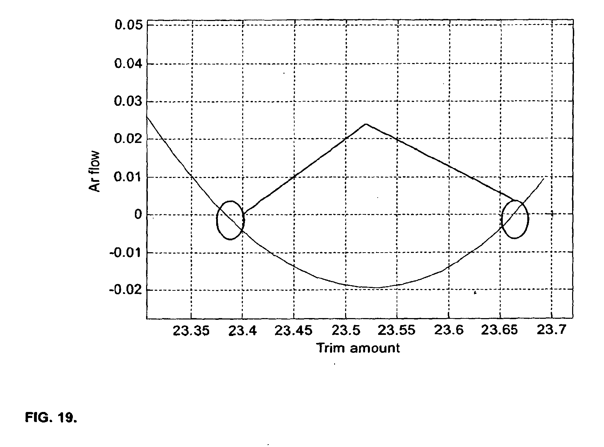

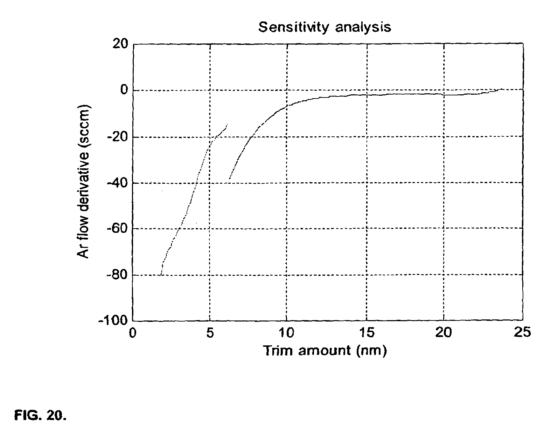

Additionally, the order of the polynomial curve-fits can be altered in order to optimize the accuracy, and robustness of each process recipe. For example, the order of the polynomial fits can be adjusted in order to maximize the range of trim amount (or argon flow rate) for a physically accurate model. For example, use of the second process recipe at high trim amounts (i.e., greater than 23 nm in FIG. 18) can lead to the occurrence of two roots for a flow rate of argon of zero; see FIG. 19. Additionally, for example, the trend of the curve-fit of the process recipe can be of the wrong direction. FIG. 20 illustrates the sensitivity of the trim amount to changes in the flow rate of argon. For instance, the first process recipe 910 and a part of the second process recipe 920 for trim amounts less than about 10 nm, the trim amount is less sensitive to changes, or errors, in the flow rate of argon. However, the second process recipe 920, when used for trim amounts in excess of about 10 nm, exhibits a highly sensitive trim amount to changes in the flow rate of argon (i. e., a change of about 2 sccm in the flow rate of argon can lead to a change in the trim amount of about 1 nm). Therefore, small errors in the control of mass flow rate can manifest as large errors in the trim amount. In an embodiment of the invention, a separate mass flow controller is utilized for each process recipe in order to maximize the resolution in mass flow rate for each processing regime. Furthermore, as illustrated in FIG. 20, when the trim amount exceeds about 23.5 nm, the curve-fit turns upward in the wrong direction.

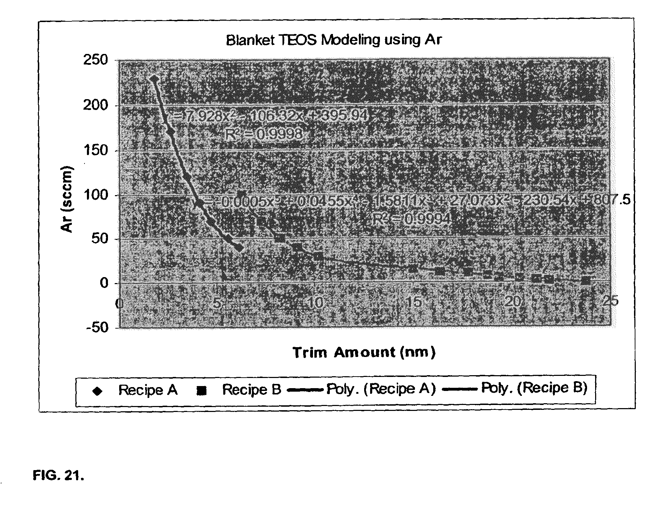

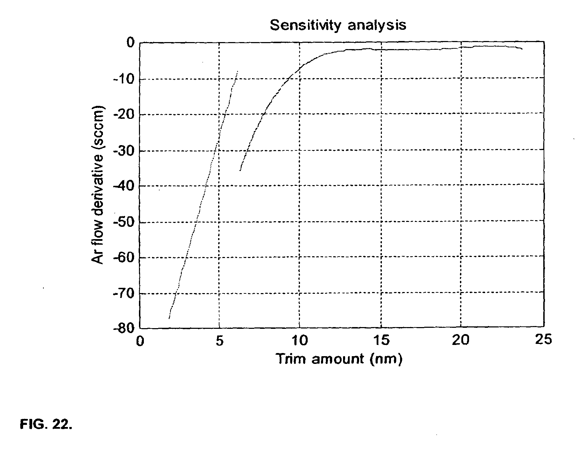

Using the data of FIG. 18, FIG. 21 presents the first curve-fit of the first process recipe 910 illustrated as a second order polynomial, and a second curve-fit of the second process recipe 920 illustrated as a fifth order polynomial. Referring to the second process recipe, the second curve-fit no longer exhibits two roots for a zero flow rate of argon. Additionally, FIG. 22 presents the sensitivity of the trim amount to changes in the flow rate of argon for the respective curve fits of FIG. 21. As depicted in FIG. 21, the trend of the trim amount as a function of change to the flow rate of argon at high trim amounts is no longer in the wrong direction.

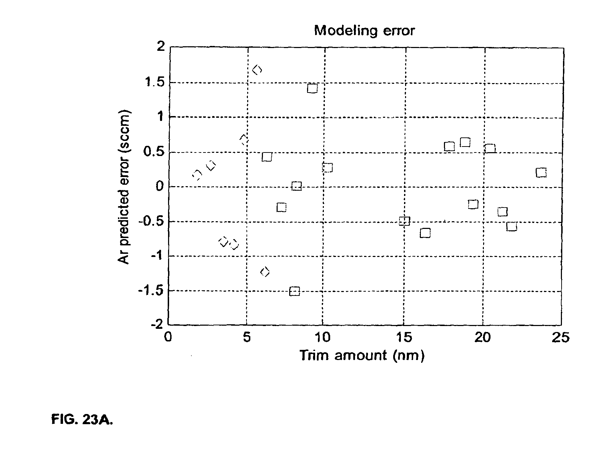

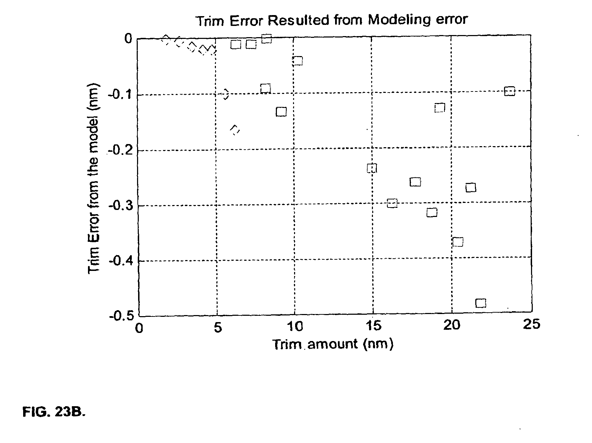

Referring now to FIG. 23A, the predicted error in the flow rate of argon (i. e., the difference between the data and the respective curve-fit) is illustrated as a function of trim amount (nm). FIG. 23B presents the error in the trim amount corresponding to the error in the flow rate of argon (i. e., using FIG. 23A and the respective curve-fits to translate the flow rate error into a trim amount error). The error in the trim amount associated with the first recipe is less than about 0.2 nm, and the error in the trim amount associated with the second process recipe is less than about 0.5 nm.

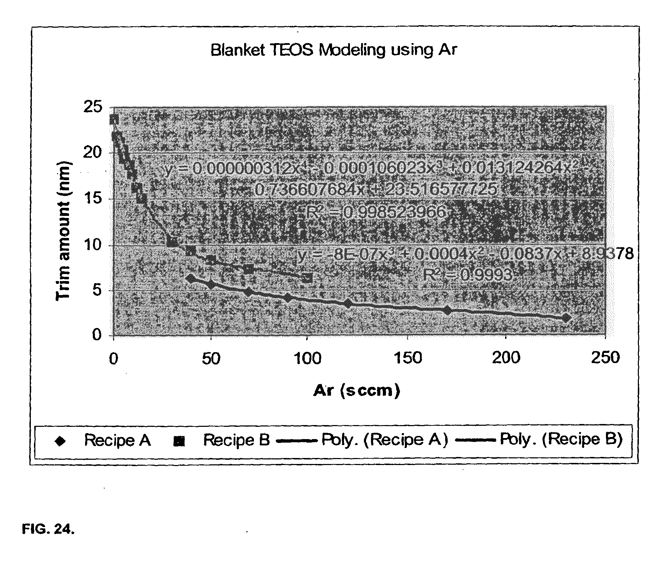

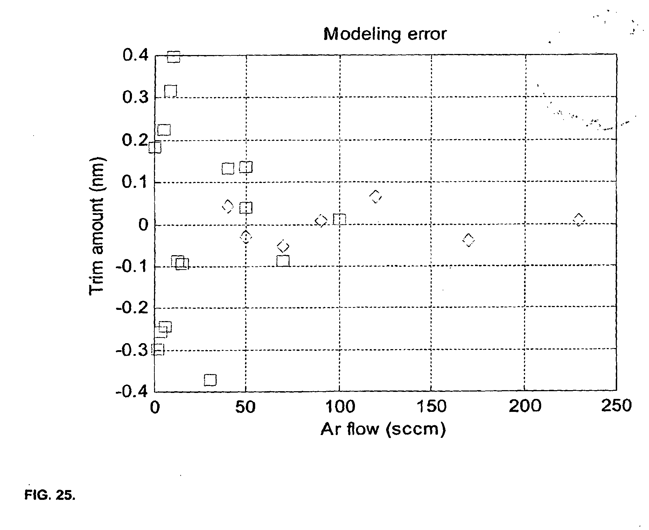

Referring now to FIG. 24, the data of FIG. 22 is inverted to illustrate the trim amount (nm) as a function of the flow rate of argon (sccm). FIG. 24 presents a first curve-fit of an inverted first process recipe illustrated as a third order polynomial, and a second curve-fit of an inverted second process recipe illustrated as a fourth order polynomial. FIG. 25 indicates that the error in the trim amount is less than about 0.1 nm for the first process recipe, and less than about 0.4 nm for the second process recipe.

Therefore, at least one process recipe comprising a curve-fit of data can be optimized in order to minimize the error in the trim amount. When polynomial curve-fitting is employed, the optimization can include optimization of the polynomial order.

Although only certain embodiments of this invention have been described in detail above, those skilled in the art will readily appreciate that many modifications are possible in the embodiments without materially departing from the novel teachings and advantages of this invention. Accordingly, all such modifications are intended to be included within the scope of this invention.

## Claims

1. A method for achieving a trim amount of a feature on a substrate in a chemical oxide removal process comprising:
setting a process recipe for said chemical oxide removal process, wherein said setting said process recipe comprises setting an amount of a first process gas, and setting an amount of a second process gas;
adjusting said process recipe for said chemical oxide removal process by setting an amount of an inert gas based on a relationship between a trim amount and an amount of inert gas added to the first and second process gases in order to achieve said trim amount,
wherein said relationship comprises, for a plurality of process regimes, a plurality of polynomial curve-fits of either said trim amount data as a function of said amount of inert gas or said amount of inert gas as a function of said trim amount data and wherein the process recipe is optimized by adjusting the order of the polynomial curve-fits;
chemically treating said feature on said substrate by exposing said substrate using said process recipe; and
substantially removing said trim amount from said feature.

2. The method of claim 1, wherein said substantially removing said trim amount from said feature comprises thermally treating said substrate by elevating the temperature of said substrate following said chemical treating.

3. The method of claim 1 or 2, wherein said substantially removing said trim amount from said feature comprises rinsing said substrate in a water solution following said chemical treating.

4. The method of one of the preceding claims, wherein said setting said amount of said first process gas includes setting an amount of HF, and said setting said amount of said second process gas includes setting an amount of NH₃.

5. The method of claim 1 or 4, wherein said setting said amount of said inert gas includes setting an amount of argon.

6. The method of one of the preceding claims, wherein said chemically treating said feature includes introducing said first process gas independently from said second process gas.

7. The method of one of the preceding claims, wherein said setting said process recipe further includes setting a pressure.

8. The method of one of the preceding claims, wherein said setting said process recipe further includes setting a temperature of said substrate.

9. The method of one of the preceding claims, wherein said setting said process recipe further includes setting a time period for chemically treating said substrate.

10. The method of one of the preceding claims, wherein said setting said process recipe further includes setting a temperature of a chemical treatment process for chemically treating said substrate.

11. The method of one of the preceding claims, wherein said chemically treating said feature includes chemically treating a silicon oxide feature.

12. The method of one of the preceding claims, further comprising:
determining said relationship, wherein said relationship is established for an amount of said first process gas, and an amount of said second process gas;
selecting a target trim amount;
selecting a target amount of inert gas for achieving said target trim amount using said relationship.

13. The method of claim 12, wherein said relationship is established for an amount of HF and amount of NH₃ as said first and second process gases.

14. The method of claim 12 or 13, wherein said relationship is further established for a pressure.

15. The method of one of claims 12 to 14, wherein said relationship is further established for a temperature of said substrate.

16. The method of one of claims 12 to 15, wherein said relationship is further established for a time period of said chemical treating.

17. The method of one of claims 12 to 16, wherein said determining said relationship includes curve-fitting with polynomial expressions either said trim amount data as a function of said amount of said inert gas or said amount of said inert gas as a function of said trim amount data.

18. The method of claim 17, further comprising:
optimizing said relationship in order to minimize an error in a trim amount, wherein said error in said trim amount is determined from translating a difference between said trim amount data and said relationship into said error in said trim amount using said relationship.

19. The method of claim 18, wherein said optimizing includes adjusting the order of said polynomial expressions.

20. The method of one of the preceding claims, wherein said chemically treating said feature includes using a separate mass flow controller for each process regime.

21. The method of claim 1, wherein the feature is a silicon oxide feature ;
the first process gas is HF, and the second process gas is NH₃;
the inert gas is argon;
wherein said amount of HF is introduced independently from said amount of said NH₃, and said amount of argon is introduced with said amount of NH₃;
wherein increasing said amount of argon corresponds to decreasing said trim amount.

## Patentansprüche

1. Verfahren zum Erreichen eines Schnittbetrags eines Merkmals auf einem Substrat in einem chemischen Oxid-Entfernungsprozess, mit folgenden Verfahrensschritten:
Einstellen einer Prozess-Rezeptur für den chemischen Oxid-Entfernungsprozess, wobei das Einstellen der Prozess-Rezeptur das Einstellen einer Menge eines ersten Prozessgases und das Einstellen einer Menge eines zweiten Prozessgases umfasst;
Justieren der Prozess-Rezeptur für den chemischen Oxid-Entfernungsprozess durch Einstellen einer Menge eines Inertgases auf der Basis einer Beziehung zwischen dem Schnittbetrag und einer Menge des Inertgases, das dem ersten und dem zweiten Prozessgas hinzugefügt wird, um den Schnittbetrag zu erreichen, wobei die Beziehung für eine Vielzahl von Prozess-Systemen eine Vielzahl von Polynomkurven-Anpassungen von entweder der Schnittbetrag-Daten als eine Funktion der Menge des Inertgases oder der Menge des Inertgases als eine Funktion der Schnittbetrag-Daten umfasst, wobei die Prozess-Rezeptur durch Justieren der Reihenfolge der Polynomkurven-Anpassungen optimiert wird;
chemisches Behandeln des Merkmals auf dem Substrat durch Spülen des Substrates unter Anwendung der Prozess-Rezeptur; und
weitgehendes Entfernen des Schnittbetrags von dem Merkmal.

2. Verfahren nach Anspruch 1, wobei das weitgehende Entfernen des Schnittbetrags von dem Merkmal die thermische Behandlung des Substrats durch Erhöhen der Temperatur des Substrats nach dem chemischen Behandeln umfasst.

3. Verfahren nach Anspruch 1 oder 2, wobei das weitgehende Entfernen des Schnittbetrags von dem Merkmal das Spülen des Substrats in einer Wasserlösung nach dem chemischen Behandeln umfasst.

4. Verfahren nach einem der vorangehenden Ansprüche, wobei das Einstellen der Menge des ersten Prozessgases das Einstellen einer Menge von Hf umfasst und das Einstellen der Menge des zweiten Gases das Einstellen einer Menge von NH₃ umfasst.

5. Verfahren nach Anspruch 1 oder 4, wobei das Einstellen der Menge des Inertgases das Einstellen einer Argon-Menge umfasst.

6. Verfahren nach einem der vorangehenden Ansprüche, wobei das chemische Behandeln des Merkmals das Einfügen des ersten Prozessgases unabhängig von dem zweiten Prozessgas umfasst.

7. Verfahren nach einem der vorangehenden Ansprüche, wobei das Einstellen der Prozess-Rezeptur ferner das Einstellen eines Drucks umfasst.

8. Verfahren nach einem der vorangehenden Ansprüche, wobei das Einstellen der Prozess-Rezeptur ferner das Einstellen einer Temperatur des Substrats umfasst.

9. Verfahren nach einem der vorangehenden Ansprüche, wobei das Einstellen der Prozess-Rezeptur ferner das Einstellen einer Zeitspanne für die chemische Behandlung des Substrats umfasst.

10. Verfahren nach einem der vorangehenden Ansprüche, wobei das Einstellen der Prozess-Rezeptur ferner das Einstellen einer Temperatur eines chemischen Behandlungsprozesses zum chemischen Behandeln des Substrats umfasst.

11. Verfahren nach einem der vorangehenden Ansprüche, wobei das chemische Behandeln des Merkmals das chemische Behandeln eines Siliziumoxid-Merkmals umfasst.

12. Verfahren nach einem der vorangehenden Ansprüche, mit den weiteren Schritten:
Ermitteln einer Beziehung, wobei die Beziehung aufgestellt ist für eine Menge des ersten Prozessgases und eine Menge des zweiten Prozessgases;
Auswählen eines Ziel-Schnittbetrags;
Auswählen einer Ziel-Menge des Inertgases zum Erzielen des Ziel-Schnittbetrags unter Verwendung der Beziehung.

13. Verfahren nach Anspruch 12, wobei die Beziehung aufgestellt wird für eine Hf-Menge und eine NH₃-Menge des ersten und des zweiten Prozessgases.

14. Verfahren nach Anspruch 12 oder 13, wobei die Beziehung ferner für einen Druck aufgestellt wird.

15. Verfahren nach einem der Ansprüche 12 bis 14, wobei die Beziehung ferner für eine Temperatur des Substrats aufgestellt wird.

16. Verfahren nach einem der Ansprüche 12 bis 15, wobei die Beziehung ferner für eine Zeitspanne der chemischen Behandlung aufgestellt wird.

17. Verfahren nach einem der Ansprüche 12 bis 16, wobei das Ermitteln der Beziehung eine Kurvenanpassung mit Polynomausdrücken entweder der Schnittbetrag-Daten als eine Funktion der Menge des Inertgases oder der Menge des Inertgases als eine Funktion der Schnittbetrag-Daten umfasst.

18. Verfahren nach Anspruch 17, mit dem weiteren Schritt:
Optimieren der Beziehung, um einen Fehler des Schnittbetrags zu minimieren, wobei der Fehler des Schnittbetrags ermittelt wird durch Übersetzen einer Differenz zwischen den Schnittbetrag-Daten und der Beziehung in einen Fehler des Schnittbetrags unter Verwendung der Beziehung.

19. Verfahren nach Anspruch 18, wobei das Optimieren das Justieren der Reihenfolge der Polynomausdrücke umfasst.

20. Verfahren nach einem der vorangehenden Ansprüche, wobei das chemische Behandeln des Merkmals die Anwendung einer eigenen Massenströmungs-Steuereinrichtung für jedes Prozess-System umfasst.

21. Verfahren nach Anspruch 1, wobei das Merkmal ein Siliziumoxidmerkmal ist;
das erste Prozessgas Hf ist und das zweite Prozessgas NH₃ ist;
das Inertgas Argon ist;
wobei die Hf-Menge unabhängig von der NH₃-Menge eingebracht wird und die Argon-Menge zusammen mit der NH₃-Menge eingebracht wird;
wobei eine Erhöhung der Argon-Menge einer Senkung des Schnittbetrags entspricht.

## Revendications

1. Procédé pour obtenir une quantité d'ajustage d'un composant sur un substrat dans un processus d'élimination d'oxyde chimique comprenant :
l'ajustement d'une recette de processus pour ledit processus d'élimination d'oxyde chimique, où ledit ajustement de ladite recette de processus comprend l'ajustement d'une quantité d'un premier gaz de processus, et l'ajustement d'une quantité d'un deuxième gaz de processus ;
l'ajustement de ladite recette de processus pour ledit processus d'élimination d'oxyde chimique par ajustement d'une quantité d'un gaz inerte sur la base d'une relation entre une quantité d'ajustage et une quantité de gaz inerte ajoutée aux premier et deuxième gaz de processus afin d'obtenir ladite quantité d'ajustage, où ladite relation comprend, pour une pluralité de régimes de processus, une pluralité d'ajustements de courbe polynomiaux desdites données de quantité d'ajustage en fonction de ladite quantité de gaz inerte ou ladite quantité de gaz inerte en fonction desdites données de quantité d'ajustage et où la recette de processus est optimisée par adaptation de l'ordre des ajustements de courbe polynomiaux ; le traitement chimique dudit composant sur ledit substrat par exposition dudit substrat au moyen de ladite recette de processus ; et
l'élimination substantielle de ladite quantité d'ajustage à partir dudit composant.

2. Procédé de la revendication 1, dans lequel ladite élimination substantielle de ladite quantité d'ajustage à partir dudit composant comprend le traitement thermique dudit substrat par augmentation de la température dudit substrat après ledit traitement chimique.

3. Procédé de la revendication 1 ou 2, dans lequel ladite élimination substantielle de ladite quantité d'ajustage à partir dudit composant comprend le rinçage dudit substrat dans une solution aqueuse après ledit traitement chimique.

4. Procédé d'une des revendications précédentes, dans lequel ledit ajustement de ladite quantité dudit premier gaz de processus comprend l'ajustement d'une quantité de HF, et ledit ajustement de ladite quantité dudit deuxième gaz de processus comprend l'ajustement d'une quantité de NH₃.

5. Procédé de la revendication 1 ou 4, dans lequel ledit ajustement de ladite quantité dudit gaz inerte comprend l'ajustement d'une quantité d'argon.

6. Procédé d'une des revendications précédentes, dans lequel ledit traitement chimique dudit composant comprend l'introduction dudit premier gaz de processus indépendamment dudit deuxième gaz de processus.

7. Procédé d'une des revendications précédentes, dans lequel ledit ajustement de ladite recette de processus comprend en outre l'ajustement d'une pression.

8. Procédé d'une des revendications précédentes, dans lequel ledit ajustement de ladite recette de processus comprend en outre l'ajustement de la température dudit substrat.

9. Procédé d'une des revendications précédentes, dans lequel ledit ajustement de ladite recette de processus comprend en outre l'ajustement de la durée du traitement chimique dudit substrat.

10. Procédé d'une des revendications précédentes, dans lequel ledit ajustement de ladite recette de processus comprend en outre l'ajustement d'une température d'un processus de traitement chimique pour traiter chimiquement ledit substrat.

11. Procédé d'une des revendications précédentes, dans lequel ledit traitement chimique dudit composant comprend le traitement chimique d'un composant en oxyde de silicium.

12. Procédé d'une des revendications précédentes, comprenant en outre :
la détermination de ladite relation, où ladite relation est établie pour une quantité dudit premier gaz de processus, et une quantité dudit deuxième gaz de processus ;
la sélection d'une quantité d'ajustage cible ;
la sélection d'une quantité de gaz inerte cible pour obtenir ladite quantité d'ajustage cible au moyen de ladite relation.

13. Procédé de la revendication 12, dans lequel ladite relation est établie pour une quantité de HF et une quantité de NH₃ en tant que lesdits premier et deuxième gaz de processus.

14. Procédé de la revendication 12 ou 13, dans lequel ladite relation est en outre établie pour une pression.

15. Procédé d'une des revendications 12 à 14, dans lequel ladite relation est en outre établie pour une température dudit substrat.

16. Procédé d'une des revendications 12 à 15, dans lequel ladite relation est en outre établie pour la durée dudit traitement chimique.

17. Procédé d'une des revendications 12 à 16, dans lequel ladite détermination de ladite relation comprend l'ajustement de courbe avec des expressions polynomiales desdites données de quantité d'ajustage en fonction de ladite quantité dudit gaz inerte ou ladite quantité dudit gaz inerte en fonction desdites données de quantité d'ajustage.

18. Procédé de la revendication 17, comprenant en outre :
l'optimisation de ladite relation afin de réduire au minimum une erreur d'une quantité d'ajustage, où ladite erreur de ladite quantité d'ajustage est déterminée à partir de la traduction d'une différence entre lesdites données de quantité d'ajustage et ladite relation de ladite erreur de ladite quantité d'ajustage au moyen de ladite relation.

19. Procédé de la revendication 18, dans lequel ladite optimisation comprend l'adaptation de l'ordre desdites expressions polynomiales.

20. Procédé d'une des revendications précédentes, dans lequel ledit traitement chimique dudit composant comprend l'utilisation d'un régulateur de débit massique séparé pour chaque régime de processus.

21. Procédé de la revendication 1, dans lequel le composant est un composant d'oxyde de silicium ;
le premier gaz de processus est HF, et le deuxième gaz de processus est NH₃ ;
le gaz inerte est l'argon ;
où ladite quantité de HF est introduite indépendamment de ladite quantité dudit NH₃,
et ladite quantité d'argon est introduite avec ladite quantité de NH₃ ;
où l'augmentation de ladite quantité d'argon correspond à la diminution de ladite quantité d'ajustage.
